(19) Europäisches Patentamt
European Patent Office
Office européen des brevets

(11) **EP 4 325 720 A1**

(12) **EUROPEAN PATENT APPLICATION**
published in accordance with Art. 153(4) EPC

(43) Date of publication:
**21.02.2024 Bulletin 2024/08**

(21) Application number: **21968531.0**

(22) Date of filing: **22.12.2021**

(51) International Patent Classification (IPC):
**H03F 1/56** *(2006.01)*    **H03F 1/02** *(2006.01)*

(52) Cooperative Patent Classification (CPC):
**H03F 1/02; H03F 1/56**

(86) International application number:
**PCT/CN2021/140419**

(87) International publication number:
**WO 2023/115382 (29.06.2023 Gazette 2023/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Suzhou Watech Electronics Co., Ltd.
Suzhou, Jiangsu 215125 (CN)**

(72) Inventor: **LIU, Haoyu
Shanghai 200127 (CN)**

(74) Representative: **dompatent von Kreisler Selting
Werner -
Partnerschaft von Patent- und Rechtsanwälten
mbB
Deichmannhaus am Dom
Bahnhofsvorplatz 1
50667 Köln (DE)**

(54) **DOHERTY AMPLIFIER AND OUTPUT NETWORK THEREOF AND DESIGN METHOD FOR DOHERTY AMPLIFIER**

(57)    Embodiments of the present application provide an output network for a Doherty amplifier, the Doherty amplifier, and a method for designing the Doherty amplifier. The output network comprises: a first sub-output network, a second sub-output network, a combined node, and a combined path matching network. The output end of the first sub-output network and the output end of the second sub-output network are both connected to the combined node, and the combined path matching network is configured to connect the combined node to a radio-frequency output end of the Doherty amplifier. The first sub-output network comprises a first series circuit formed by connecting a first inductor and a first transmission line in series. The second sub-output network comprises a second series circuit composed of a second inductor and a second transmission line. The first series circuit is connected to the output end of a main amplifier and the combined node. The second series circuit is connected between the output end of an auxiliary amplifier and the combined node. The first series circuit and the second series circuit are configured to enable the node impedance at the combined node to be matched to the target load impedance of the main amplifier and the auxiliary amplifier.

FIG. 3

**Description**

FIELD OF THE INVENTION

The present disclosure relates to the field of wireless communication, more specifically, to an output network for a Doherty amplifier, a Doherty amplifier comprising the output network, and a design method for the Doherty amplifier.

BACKGROUND OF THE INVENTION

With the development of wireless communication technology, the required communication bandwidth for wireless communication systems continues to increase, and the modulation signals used in wireless communication systems are becoming more and more complex. In order to meet the requirements for bandwidth, efficiency, size, and other aspects of wireless communication systems, higher and higher requirements have been placed on the efficiency, back-off power range, operating bandwidth, and size of power amplifiers (PA) in the radio-frequency front-end system of wireless communication networks.

In the related art, a Doherty amplifier can be used in the radio-frequency front-end of wireless communication systems (including base stations, broadcasting, and mobile terminals) to improve the efficiency of the wireless communication system. However, due to the increasing number of radio-frequency chain units (including power amplifiers and antennas, etc.) in the radio-frequency front-end system and the Doherty amplifier having many components and large circuit sizes, it is difficult to meet the design requirements for miniaturizing the amplifiers. Additionally, the load modulation of the Doherty amplifier is implemented with a quarter-wave transmission line, which results in a narrow operating bandwidth and a small back-off power range at high-efficiency. Therefore, it is challenging for wireless communication systems to meet the increasing requirements for bandwidth, efficiency, and size with conventional Doherty amplifiers. Currently, there are some proposals to increase the bandwidth by improving the load modulation network of the Doherty amplifier, which often lead to an increase in the size of the Doherty amplifier, thus difficult to have a good balance between efficiency, bandwidth, back-off power range, and circuit size in the amplifier.

SUMMARY OF THE INVENTION

In view of above, the present disclosure provides an output network for a Doherty amplifier, a Doherty amplifier comprising the output network, and a design method for the Doherty amplifier, so as to alleviate, reduce, or even eliminate the problems mentioned above.

The embodiment of the present disclosure provides an output network for a Doherty amplifier, the Doherty amplifier comprising a main amplifier and an auxiliary amplifier, and the output network comprising: a first sub-output network corresponding to the main amplifier, a second sub-output network corresponding to the auxiliary amplifier, a combining node, and a merging matching network. An output end of the first sub-output network and an output end of the second sub-output network are both connected to the combining node, the merging matching network configured to connect the combining node to a radio-frequency output end of the Doherty amplifier, the first sub-output network comprising a first series circuit formed by a first inductor and a first transmission line in series, and the second sub-output network comprising a second series circuit formed by a second inductor and a second transmission line, the first series circuit being connected between an output end of the main amplifier and the combining node, the second series circuit being connected between an output end of the auxiliary amplifier and the combining node, and the first series circuit and the second series circuit configured to enable the node impedance at the combining node to be matched to the target load impedance of the main amplifier and the auxiliary amplifier.

According to some embodiments of the present disclosure, at least one of the first transmission line and the second transmission line is a microstrip line.

According to some embodiments of the present disclosure, the merging matching network comprises a third transmission line, a fourth transmission line, and a first capacitor, the third transmission line being connected between the combining node and an output end of the merging matching network, the fourth transmission line being connected between the output end of the merging matching network and a direct current voltage terminal, one end of the first capacitor being connected to the direct current voltage terminal, and the other end of the first capacitor being grounded, and the direct current voltage terminal configured to provide a direct current bias voltage to the main amplifier and the auxiliary amplifier via the fourth transmission line, the third transmission line, the first sub-output network, and the second sub-output network.

According to some embodiments of the present disclosure, the merging matching network comprises a fifth transmission line, a sixth transmission line, a seventh transmission line, and a second capacitor, where the fifth transmission line being connected between the combining node and the output end of the merging matching network, the sixth transmission line being connected between the combining node and a direct current voltage terminal, one end of the seventh transmission line being connected to the output end of the merging matching network, and the other end of the seventh transmission line being floating, one end of the second capacitor being connected to the direct current voltage terminal, and the other end of the second capacitor being grounded, and the direct current voltage terminal configured to provide a direct current bias voltage to the main amplifier and the auxiliary amplifier via the sixth transmission line, the first sub-output network, and the second sub-output network.

According to some embodiments of the present disclosure, the merging matching network comprises a third inductor, a fourth inductor, and a third capacitor, the third inductor and the third capacitor being connected in series between a direct current voltage terminal and a ground terminal, the combining node being connected to a connection point between the third inductor and the third capacitor, where the fourth inductor being connected between the connection point between the third inductor and the third capacitor and the output end of the merging matching network, and the direct current voltage terminal configured to provide a direct current bias voltage to the main amplifier and the auxiliary amplifier via the third inductor, the first sub-output network, and the second sub-output network.

According to some embodiments of the present disclosure, the merging matching network further comprises an output capacitor, the output capacitor being connected between the output end of the merging matching network and the radio-frequency output end of the Doherty amplifier, and configured to block a direct current signal from the direct current voltage terminal from being transmitted to the radio-frequency output end of the Doherty amplifier.

According to some embodiments of the present disclosure, the merging matching network is configured to enable the node impedance to be present in a complex form.

According to some embodiments of the present disclosure, at least one of the first inductor and the second inductor comprises a plurality of bonding wires.

According to some embodiments of the present disclosure, at least one of the first inductor and the second inductor comprises a microstrip line.

According to some embodiments of the present disclosure, at least one of the first transmission line and the second transmission line comprises a strip line, a coplanar waveguide, or a substrate integrated waveguide.

Another embodiment of the present disclosure provides a Doherty amplifier comprising: a main amplifier; an auxiliary amplifier; and an output network as described in any of the embodiments mentioned above of the present disclosure, the output network configured to receive a first amplified signal output from the main amplifier and a second amplified signal output from the auxiliary amplifier, so as to combine the first amplified signal and the second amplified signal at the combining node to be provided to the radio-frequency output end to the Doherty amplifier.

According to some embodiments of the present disclosure, the Doherty amplifier comprises a carrier signal input path providing a carrier signal to the main amplifier to generate the first amplified signal, and a peak signal input path providing a peak signal to the auxiliary amplifier to generate the second amplified signal, the Doherty amplifier comprising a phase delay member located in at least one of the carrier signal input path and the peak signal input path, the phase delay member configured to form a phase difference between the carrier signal provided to the main amplifier and the peak signal provided to the auxiliary amplifier, and the phase difference being less than 90 degrees.

According to some embodiments of the present disclosure, both the main amplifier and the auxiliary amplifier comprise transistors, a first characteristic impedance $Z_{Main}$ of the first transmission line, a first electrical angle $\theta_{Main}$ of the first transmission line, a second characteristic impedance $Z_{Aux}$ of the second transmission line, and a second electrical angle $\theta_{Aux}$ of the second transmission line are:

$$Z_{Main} = \frac{\sin\theta_{IN} \cdot R_{opt}}{\sqrt{\alpha X} \cdot \sin\theta_{Main}} - \omega \cdot L_{P1} \cdot \cot\theta_{Main}$$

$$Z_{Aux} = \frac{(1+\alpha) \cdot \sin\theta_{IN} \cdot \cos\theta_{IN} \cdot R_{opt}}{\sqrt{\alpha X} \cdot \sin\theta_{Aux}} - \omega \cdot L_{P2} \cdot \cot\theta_{Aux}$$

$$\theta_{Main} = \cos^{-1}\left[\frac{\sin\theta_{IN} \cdot \omega \cdot C_{DS} \cdot R_{opt} + \alpha \cdot \cos\theta_{IN}}{\sqrt{\alpha X}}\right]$$

$$\theta_{Aux} = \cos^{-1}\left[\frac{(1-2\alpha) \cdot \tan\theta_{IN} \cdot \omega \cdot C_{DS} \cdot R_{opt} - \alpha}{(1-\alpha) \cdot \sqrt{\alpha X}}\right]$$

where $\theta_{IN}$ represents the phase difference, $\omega$ is the center operating frequency of the Doherty amplifier, $R_{opt}$ is the optimal operating load of the transistor, $L_{P1}$ represents a first inductance value of the first inductor, $L_{P2}$ represents a second inductance value of the second inductor, $C_{DS}$ is the drain parasitic capacitance of the transistor, $\alpha$ represents the power level of the auxiliary amplifier turned on to operate, and x is a constant.

According to some embodiments of the present disclosure, the phase difference $\theta_{IN}$ is

$$\theta_{IN} = \tan^{-1}\left[\sqrt{\frac{\alpha \cdot (2 - \alpha)}{(1 - 2\alpha)}}\right],$$

where $\alpha$ is greater than 0 and less than 0.5, where $1 \leq x \leq 10$.

According to some embodiments of the present disclosure, the node impedance $Z_{combine}$ at the combining node satisfies the following equations:

$$\frac{1}{Z_{combine}} = \frac{x}{R_{opt}} + j\frac{\cos\theta_{Main} - (\omega \cdot L_{P1} \cdot \sin\theta_{Main})/Z_{Main} - \delta}{Z_{Main} \cdot \sin\theta_{Main} + \omega \cdot L_{P1} \cdot \cos\theta_{Main}}$$

$$\delta = \frac{\frac{\omega \cdot L_{P2} \cdot \sin\theta_{Aux}}{Z_{Aux}} \cdot \sqrt{\frac{x}{\alpha} \cdot \frac{\alpha^2}{1-\alpha}} - \cos\theta_{Aux}}{(1+\alpha) \cdot \cos\theta_{IN}}$$

According to some embodiments of the present disclosure, the Doherty amplifier comprises a plurality of auxiliary amplifiers, and the output network comprises a plurality of second sub-output networks corresponding to the plurality of auxiliary amplifiers, the first sub-output network configured to receive the first amplified signal output from the main amplifier, and each second sub-output network configured to receive the second amplified signal output from the corresponding auxiliary amplifier of the plurality of auxiliary amplifiers, so as to combine the first amplified signal and the second amplified signal output from each auxiliary amplifier at the combining node to be provided to a radio-frequency output to the Doherty amplifier.

Another embodiment of the present disclosure provides a design method for a Doherty amplifier, the Doherty amplifier comprising a main amplifier, at least one auxiliary amplifier, and an output network described in any of the embodiments mentioned above, and the method comprises: selecting transistors for the main amplifier and the auxiliary amplifier; determining a target back-off power range of the Doherty amplifier, and according to the target back-off power range, the first inductance value of the first inductor, the second inductance value of the second inductor, the drain parasitic capacitance of the transistors, the center operating frequency of the Doherty amplifier, and the optimal operating load, determining a first characteristic impedance of the first transmission line, a first electrical angle of the first transmission line, a second characteristic impedance of the second transmission line and a second electrical angle of the second transmission line; and according to the center operating frequency, the first characteristic impedance of the first transmission line, the first electrical angle of the first transmission line, the second characteristic impedance of the second transmission line, the second electrical angle of the second transmission line, the optimal operating load, the first inductance value of the first inductor, the second inductance value of the second inductor, and the target back-off power range, determining a node impedance at the combining node.

According to some embodiments of the present disclosure, the step of according to the target back-off power range, the first inductance value of the first inductor, the second inductance value of the second inductor, the drain parasitic capacitance of the transistors, the center operating frequency of the Doherty amplifier, and the optimal operating load, determining a first characteristic impedance of the first transmission line, a first electrical angle of the first transmission line, a second characteristic impedance of the second transmission line and a second electrical angle of the second transmission line comprises: respectively calculating a first characteristic impedance $Z_{Main}$ of the first transmission line, a first electrical angle $\theta_{Main}$ of the first transmission line, a second characteristic impedance $Z_{Aux}$ of the second transmission line and a second electrical angle $\theta_{Aux}$ of the second transmission line, via the following equations:

$$Z_{Main} = \frac{\sin\theta_{IN} \cdot R_{opt}}{\sqrt{\alpha x} \cdot \sin\theta_{Main}} - \omega \cdot L_{P1} \cdot \cot\theta_{Main}$$

$$Z_{Aux} = \frac{(1+\alpha) \cdot \sin\theta_{IN} \cdot \cos\theta_{IN} \cdot R_{opt}}{\sqrt{\alpha x} \cdot \sin\theta_{Aux}} - \omega \cdot L_{P2} \cdot \cot\theta_{Aux}$$

$$\theta_{Main} = \cos^{-1}\left[\frac{\sin\theta_{IN} \cdot \omega \cdot C_{DS} \cdot R_{opt} + \alpha \cdot \cos\theta_{IN}}{\sqrt{\alpha x}}\right]$$

$$\theta_{Aux} = \cos^{-1}\left[\frac{(1 - 2\alpha) \cdot \tan\theta_{IN} \cdot \omega \cdot C_{DS} \cdot R_{opt} - \alpha}{(1 - \alpha) \cdot \sqrt{\alpha x}}\right],$$

where $\theta_{IN}$ represents the phase difference, $\omega$ is the center operating frequency of the Doherty amplifier, $R_{opt}$ is the optimal operating load of the transistors, $L_{P1}$ represents the first inductance value of the first inductor, $L_{P2}$ represents the second inductance value of the second inductor, $C_{DS}$ is the drain parasitic capacitance of the transistors, $\alpha$ represents the power level coefficient that enables the auxiliary amplifier to turn on, and x is a constant; and
the step of according to the center operating frequency, the first characteristic impedance of the first transmission line , the first electrical angle of the first transmission line , the second characteristic impedance of the second transmission line , the second electrical angle of the second transmission line , the optimal operating load, the first inductance value of the first inductor, the second inductance value of the second inductor, and the target back-off power range, determining a node impedance at the combining node comprises: determining a node impedance $Z_{combine}$ at the combining node via the following equations:

$$\frac{1}{Z_{combine}} = \frac{x}{R_{opt}} + j\frac{\cos\theta_{Main} - (\omega \cdot L_{P1} \cdot \sin\theta_{Main})/Z_{Main} - \delta}{Z_{Main} \cdot \sin\theta_{Main} + \omega \cdot L_{P1} \cdot \cos\theta_{Main}}$$

$$\delta = \frac{\frac{\omega \cdot L_{P2} \cdot \sin\theta_{Aux}}{Z_{Aux}} - \sqrt{\frac{x}{\alpha} \cdot \frac{\alpha^2}{1-\alpha}} - \cos\theta_{Aux}}{(1+\alpha) \cdot \cos\theta_{IN}}$$

where the target back-off power range is $10 \cdot \log\left(\frac{2}{\alpha}\right) dB$ .

In the output network for the Doherty amplifier according to some embodiments of the present disclosure, providing a first sub-output network corresponding to the main amplifier of the Doherty amplifier, a second sub-output network corresponding to the auxiliary amplifier of the Doherty amplifier, a combining node, and a merging matching network. The first sub-output network comprises a first series circuit formed by a first inductor and a first transmission line connected in series, and the second sub-output network comprises a second series circuit formed by a second inductor and a second transmission line. The first series circuit and the second series circuit are configured to match the node impedance at the combining node to the target load impedance of the main amplifier and the auxiliary amplifier, so that the Doherty amplifier can be operated efficiently from low power to high power, thereby achieving a deep power back-off (i.e., a large power back-off range) and a wide operating bandwidth for load modulation of the Doherty amplifier. On the other hand, the first series circuit and the second series circuit have few components, thereby simplifying the configurations of the first sub-output network and the second sub-output network, which is conducive to miniaturizing design of the Doherty amplifier.
According to the embodiments described in the following, these and other aspects of the present disclosure will become clear and clarified with reference to the embodiments described in the following.

BRIEF DESCRIPTION OF THE DRAWINGS

In the description of exemplary embodiments below, in conjunction with the accompanying drawings, the technical proposal of the present disclosure discloses more details, features, and advantages, where:

FIG. 1A schematically illustrates an exemplary schematic diagram of a Doherty amplifier in the related art;
FIG. 1B schematically illustrates an exemplary circuit structure of a matching network for a Doherty amplifier in the related art;
FIG. 2 schematically illustrates an exemplary schematic diagram of an improved Doherty amplifier in the related art;
FIG. 3 schematically illustrates an exemplary schematic diagram of an output network for a Doherty amplifier according to some embodiments of the present disclosure;
FIG. 4A schematically illustrates an exemplary schematic diagram of load modulation implemented by the output network in FIG. 3 under low power according to some embodiments of the present disclosure;

FIG. 4B schematically illustrates an exemplary schematic diagram of load modulation implemented by the output network in FIG. 3 under high power according to some embodiments of the present disclosure;

FIG. 5 schematically illustrates an exemplary schematic diagram of a merging matching network according to some embodiments of the present disclosure;

FIG. 6 schematically illustrates an exemplary schematic diagram of a merging matching network according to some other embodiments of the present disclosure;

FIG. 7 schematically illustrates an exemplary schematic diagram of a merging matching network according to some other embodiments of the present disclosure;

FIG. 8A schematically illustrates an exemplary circuit structure of a Doherty amplifier according to some embodiments of the present disclosure;

FIG. 8B schematically illustrates an exemplary circuit structure of a Doherty amplifier according to some other embodiments of the present disclosure;

FIG. 8C schematically illustrates an exemplary circuit structure of a Doherty amplifier according to some other embodiments of the present disclosure;

FIG. 9 schematically illustrates an exemplary circuit structure of a first inductor or a second inductor according to some embodiments of the present disclosure;

FIG. 10A schematically illustrates a performance example chart of a Doherty amplifier according to some embodiments of the present disclosure;

FIG. 10B schematically illustrates a performance example chart of a Doherty amplifier according to some other embodiments of the present disclosure;

FIG. 11 schematically illustrates an exemplary schematic diagram of a Doherty amplifier according to another embodiment of the present disclosure;

FIG. 12 schematically illustrates a flowchart of a method for designing a Doherty amplifier according to some embodiments of the present disclosure;

FIG. 13A schematically illustrates an example chart of the characteristic impedance values of the first transmission line and the second transmission line according to some embodiments of the present disclosure;

FIG. 13B schematically illustrates an example chart of the electrical angle values of the first transmission line and the second transmission line according to some embodiments of the present disclosure;

FIG. 13C schematically illustrates an example chart of the relationship between the first characteristic impedance of the first transmission line and the first inductance value of the first inductor according to some embodiments of the present disclosure;

FIG. 13D schematically illustrates an example chart of the relationship between the second characteristic impedance of the second transmission line and the second inductance value of the second inductor according to some embodiments of the present disclosure.

DETAILED DESCRIPTION OF THE EMBODIMENTS

The following description of several embodiments of the present disclosure will be provided with reference to the accompanying drawings in order to enable those skilled in the art to implement the technical schemes of the present disclosure. The technical schemes of the present disclosure can be embodied in various forms and for various purposes, and should not be limited to the embodiments described in this document. The provision of these embodiments is to make the technical schemes of the present disclosure clear and complete, but these embodiments do not limit the scope of protection of the present disclosure.

Unless otherwise defined, all terms used herein (including technical terms and scientific terms) have the same meanings as those commonly understood by those skilled in the art to which the present disclosure belongs. It is further understood that terms such as those defined in commonly used dictionaries should be interpreted as having the same meanings as those in the relevant field and/or the context of this specification, and should not be interpreted in an idealized or overly formal sense unless explicitly defined as such in this document.

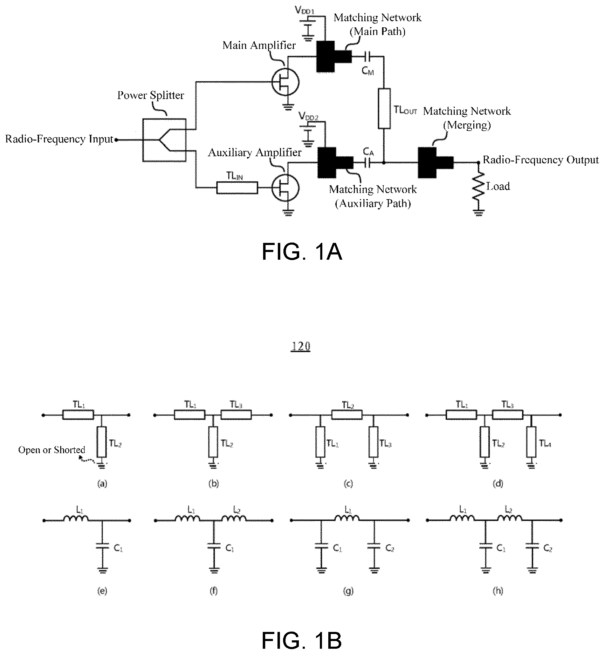

FIG. 1A schematically illustrates an exemplary schematic diagram 110 of a Doherty amplifier in the related art. As shown in FIG. 1A, a Doherty amplifier comprises two amplifiers (a main amplifier and an auxiliary amplifier). The main amplifier and the auxiliary amplifier respectively connected to two output ends of a power splitter. In addition, $TL_{IN}$ is responsible for adjusting the phase of two signals (i.e., the input signals of the main amplifier and the auxiliary amplifier) output from the power splitter to meet the operating requirements of load traction of the Doherty amplifier. The output side of the Doherty amplifier comprises four sub-networks: 1) main path matching network, which provides a direct current bias voltage $V_{DD1}$ and matching the optimal load $Z_{opt, M}$ for the main amplifier; 2) auxiliary path matching network, which provides a direct current bias voltage $V_{DD2}$ and matches the optimal load $Z_{opt, A}$ for the auxiliary amplifier; 3) merging matching network, which matches the radio-frequency output load of the amplifier to a combining node impedance; 4) quarter-wave transmission line $TL_{OUT}$, which achieves load traction (load modulation) for the Doherty amplifier. $V_{DD1}$ and $V_{DD2}$ are the drain direct current bias voltages of the main amplifier and the auxiliary amplifier, respectively, and $C_M$ and Ca, are direct current blocking capacitors. The main amplifier operates in class B or AB, while the auxiliary amplifier operates in class C. The two amplifiers do not operate alternately, but the main amplifier always operates, and the auxiliary amplifier starts operating when the input power reaches the set peak value. The quarter-wave transmission line in the output path of the main amplifier can provide phase compensation, so that the output signal in the output path of the main amplifier and the output signal in the output path of the auxiliary amplifier have the same phase at the combining node C.

In the related art, there are various schemes for implementing the main path matching network and the auxiliary path matching network as described above. As shown in FIG. 1B, the matching network usually comprises a plurality of transmission lines, capacitors, and inductors, which increase the overall complexity and circuit size of the Doherty amplifier. With the continuous development of communication technology, multiple-input multiple-output (MIMO) systems are widely used. The radio-frequency front-end system of the MIMO system comprises a plurality of (e.g., tens or even hundreds of) radio-frequency chains, which pose increasingly high requirements for the miniaturizing design of power amplifiers in the radio-frequency chains. However, conventional schemes have high complexity, use many components, and have large circuit size, making it difficult to meet the design requirements of miniaturized amplifiers.

On the other hand, the increasing number of circuit components brings more problems to the integrated design of power amplifiers. It not only increases the design difficulty and overall circuit size, but also increases the chip cost and circuit loss, and reduces the efficiency of the power amplifier. This makes the design of high-efficiency, energy-saving, and low-cost systems more difficult.

In addition, with the continuous iteration of communication systems, the communication bandwidth is increasing exponentially. For example, in the 5G scenario, the communication bandwidth has reached 500MHz or even higher, which poses a high challenge to the operating bandwidth of power amplifiers. In FIG. 1A, the load modulation of the Doherty amplifier is implemented by the quarter-wave transmission line $TL_{OUT}$, which has a narrow operating bandwidth (often less than 200MHz). Therefore, this architecture cannot meet the requirements of broadband operating in today's systems.

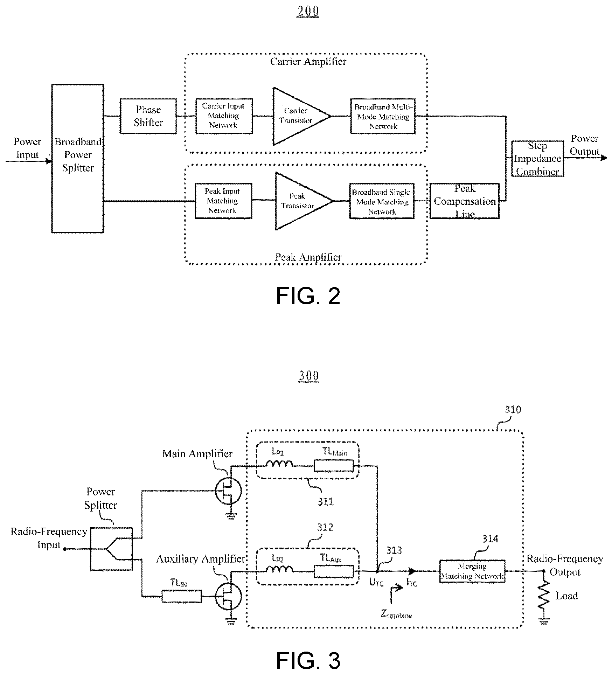

FIG. 2 schematically illustrates an exemplary schematic diagram of an improved Doherty amplifier in the related art. As shown in FIG. 2, the improved Doherty amplifier comprises a broadband power splitter, a phase shifter, a carrier amplifier, a peak amplifier, a peak compensation line, and a step impedance combiner, the carrier amplifier comprising a carrier input matching network, a carrier transistor, and a broadband multi-mode matching network connected in sequence; the peak amplifier comprising a peak input matching network, a peak transistor, and a broadband single-mode matching network connected in sequence; the broadband power splitter receiving an input power and connected to the phase shifter and the peak input matching network respectively; the phase shifter connected to the carrier input matching network; the broadband single-mode matching network connected to the peak compensation line; and the step impedance combiner connected to the broadband multi-mode matching network and the peak compensation line for power output. The matching network of the improved Doherty amplifier shown in FIG. 2 can optimize the bandwidth, the efficiency, and the back-off power range of the Doherty amplifier. However, these existing schemes require a large number of components to replace the conventional matching network of the Doherty amplifier, which further increases the size of the amplifier circuit, making it difficult to achieve miniaturizing and integrated design of the power amplifier.

FIG. 3 schematically illustrates an exemplary schematic diagram of an output network 310 for a Doherty amplifier according to some embodiments of the present disclosure.

As shown in FIG. 3, the output network 310 comprises a first sub-output network 311 corresponding to the main amplifier of the Doherty amplifier, a second sub-output network 312 corresponding to the auxiliary amplifier of the Doherty amplifier, a combining node 313, and a merging matching network 314. The output end of the first sub-output network 311 and the output end of the second sub-output network 312 are both connected to the combining node 313, and the merging matching network 314 is configured to connect the combining node to the radio-frequency output end of the Doherty amplifier.

By way of example, the first sub-output network 311 comprises a first series circuit formed by a first inductor $L_{P1}$ and a first transmission line $TL_{Main}$ connected in series, and the second sub-output network 312 comprises a second series circuit formed by a second inductor $L_{P2}$ and a second transmission line $TL_{Aux}$. The first series circuit is configured to be connected between the output end of the main amplifier and the combining node 313, and the second series circuit is configured to be connected between the output end of the auxiliary amplifier and the combining node 313. The first series circuit and the second series circuit are configured to match the node impedance $Z_{combine}$ at the combining node 313 to the target load impedance of the main amplifier and the auxiliary amplifier. As shown in FIG. 3, $Z_{combine}$ is the equivalent impedance seen from the combining node 313 towards the merging matching network 314, and in some cases, it can be regarded as the ratio of the voltage $U_{TC}$ at the combining node 313 to the current $I_{TC}$ flowing into the merging matching network 314.

In the embodiment shown in FIG. 3, the first series circuit mentioned above forms the first sub-output network 311, and the second series circuit mentioned above forms the second sub-output network 312, but this does not exclude the possibility that the first sub-output network and the second sub-output network comprise other elements. For example, in other embodiments, the first sub-output network 311 may also comprise other circuit elements outside the first series circuit, such as capacitors for isolating direct current; similarly, the second sub-output network 312 may also comprise other circuit elements outside the second series circuit, such as capacitors for isolating direct current. In addition, the combining node 313 indicates the common connection point of the first sub-output network 311, the second sub-output network 312, and the merging matching network 314. By way of example, the combining node 313 can be the common electrical connection point of the first sub-output network 311, the second sub-output network 312, and the merging matching network 314. The combining node 313 can also be an electrical node at the output end of the first sub-output network 311, be an electrical node at the output end of the second sub-output network 312, or even be an electrical node at the input end of the merging matching network 314.

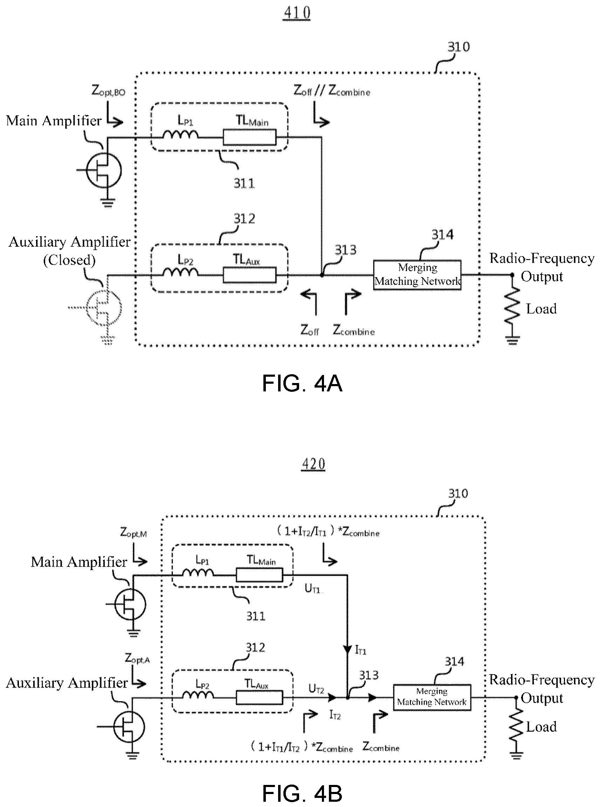

Specifically, the impedance matching process of the output network is illustrated below in conjunction with FIG. 4A and FIG. 4B.

As shown in FIG. 4A, at low power, the auxiliary amplifier is not turned on, so it can be equivalent to an open state. At this time, the path in which the second sub-output network 312 is located (referred to as the auxiliary path hereinafter) provides an auxiliary impedance $Z_{off}$ at the combining node 313, which is connected in parallel with the node impedance $Z_{combine}$ at one end of the path in which the first sub-output network 311 is located (referred to as the main path hereinafter).

At back-off power, the first series circuit (comprising a first inductor $L_{P1}$ and a first transmission line $TL_{Main}$) can convert the parallel impedance $Z_{off}//Z_{combine}$ of the auxiliary path impedance $Z_{off}$ and the node impedance $Z_{combine}$ into the target load impedance of the main amplifier at back-off power ($Z_{opt, BO}$ in FIG. 4A). For the main amplifier or the auxiliary amplifier (usually implemented as a transistor), the target load impedance indicates the optimal power matching impedance of the amplifier at a specific power level, that is, the target load impedance can make the amplifier achieve the optimal power matching impedance at a specific power level. The target load impedance depends on the parameters of the amplifier itself and the actual power level, which can be obtained by theoretical calculation or experimental measurement. The first series circuit can convert the parallel impedance $Z_{off}//Z_{combine}$ into the target load impedance $Z_{opt, BO}$ of the main amplifier at the back-off power, so that the main amplifier can still operate efficiently at the back-off power.

As shown in FIG. 4B, at high power, the auxiliary amplifier is turned on, and the current flowing through the auxiliary path is $I_{T2}$, while the current flowing through the main path is $I_{T1}$. According to Kirchhoff's voltage law and Kirchhoff's current law, the combine equivalent impedance of the main path at this time is $(1+I_{T2}/I_{T1})*Z_{combine}$, and the combine equivalent impedance of the auxiliary path is $(1+I_{T1}/I_{T2})*Z_{combine}$. Therefore, the current $I_{T2}$ can dynamically modulate the combine equivalent impedance of the main path and the combine equivalent impedance of the auxiliary path. At saturation power, the first series circuit (comprising a first inductor $L_{P1}$ and a first transmission line $TL_{Main}$) can convert the combine equivalent impedance $(1+I_{T2}/I_{T1})*Z_{combine}$ of the main path into the target load impedance of the main amplifier ($Z_{opt, M}$ in FIG. 4B) at saturation power. The second series circuit (comprising a second inductor $L_{P2}$ and a second transmission line $TL_{Aux}$) can convert the combine equivalent impedance $(1+I_{T1}/I_{T2})*Z_{combine}$ of the auxiliary path into the target load impedance of the auxiliary amplifier ($Z_{opt, A}$ in FIG. 4B) at saturation power. The first series circuit and the second series circuit can convert the combine equivalent impedance of the main path and the combine equivalent impedance of the auxiliary path into the corresponding target load impedance of the main amplifier and the auxiliary amplifier at saturation power, respectively, so that both the main amplifier and the auxiliary amplifier can operate efficiently at saturation power.

The term "combine equivalent impedance" mentioned here refers to the equivalent impedance seen from the combining node (i.e., the combining node 313) on a certain path. By way of example, as shown in FIG. 4B, the combine equivalent impedance of the main path is the ratio of the output voltage $U_{T1}$ of the main path to the output current $I_{T1}$ of the main path, and the combine equivalent impedance of the auxiliary path is the ratio of the output voltage $U_{T2}$ of the auxiliary path to the output current $I_{T2}$ of the auxiliary path. The first inductor $L_{P1}$ and the second inductor $L_{P2}$ can be implemented in various forms (e.g., wire bonding).

The main amplifier and the auxiliary amplifier can comprise, but are not limited to, power transistors based on VDMOS, LDMOS, or GaN. Different transistor technologies provide different performance advantages in terms of output power, gain, and performance. For example, the type of transistor can be selected according to requirements such as frequency, bandwidth, and cost. According to some embodiments of the present disclosure, the main amplifier and the auxiliary amplifier can be the same type of power transistor (such as GaN-based power transistors), and the parameters and size of the transistors used as the main amplifier and the auxiliary amplifier can be completely the same. In other embodiments, the transistor used as the main amplifier and the transistor used as the auxiliary amplifier differ in at least one aspect of the transistor type, parameters, and size. According to other embodiments of the present disclosure, the main amplifier or the auxiliary amplifier may comprise a plurality of transistors. The specific implementation of the main amplifier and the auxiliary amplifier is not specifically limited herein.

By using the output network 310 shown in FIG. 3 in the Doherty amplifier, the node impedance $Z_{combine}$ at the combining node 313 can be matched to the target load impedance of the main amplifier and the auxiliary amplifier of the Doherty amplifier at different power levels, so that the main amplifier can still operate efficiently at back-off power, and the main amplifier and the auxiliary amplifier are both able to operate efficiently at saturation power, that is, the Doherty amplifier can operate efficiently at different power levels. In addition, compared to the output network in conventional Doherty amplifiers, the number of components comprised in the output network 310 is greatly reduced, the configuration of the output network 310 is simplified, and the size of the related circuit is reduced, which can meet the design requirements of miniaturized amplifiers. In addition, as will be further described below, by reasonably setting the characteristic parameters of the inductors and transmission lines in the first series circuit and the second series circuit, the Doherty amplifier can have a larger operating bandwidth and a deeper back-off power (i.e., a larger back-off power range) while operating efficiently.

In some embodiments, at least one of the first transmission line and the second transmission line is a microstrip line. Microstrip lines currently are the most commonly used planar transmission line in hybrid microwave integrated circuits and monolithic microwave integrated circuits. It is a strip-shaped conductor (signal line) isolated from the ground plane by a dielectric. Factors affecting the characteristic impedance of microstrip lines comprise the thickness, the width, the distance from the ground plane, and the dielectric constant of the microstrip lines. The length of the microstrip lines can correspond to the electrical angle of the microstrip lines. By way of example, microstrip lines can be used to implement the first transmission line and the second transmission line. Accordingly, the length, the width, and other size parameters of the microstrip lines can be configured based on the characteristic impedance and the electrical angle of the first transmission line and the second transmission line. By using microstrip lines to implement the first transmission line and the second transmission line, transmission lines that meet the requirements of characteristic parameters can be obtained, thereby enabling the Doherty amplifier to have smaller circuit size, higher operating efficiency, larger operating bandwidth, and deeper back-off power (i.e., larger range of back-off power). Specifically, by using a substrate with a high dielectric constant, microstrip lines can be implemented to further reduce the size of the related circuit.

In other embodiments, at least one of the first transmission line and the second transmission line comprises a strip line, a coplanar waveguide, or a substrate integrated waveguide. Strip lines are high-frequency transmission conductors placed between two parallel ground planes (or power planes) and separated by a dielectric. Strip lines have advantages such as small size, light weight, wide bandwidth, high quality factor, simple process, and low cost, making them suitable for producing high-performance (wide bandwidth, high quality factor, high isolation) passive components. Coplanar waveguides (CPW) are formed by creating a center conductor strip on one surface of a dielectric substrate and creating conductor planes on both sides adjacent to the center conductor strip. In the millimeter wave frequency range, CPW have lower losses compared to microstrip line circuits and strip line circuits. Substrate integrated waveguide (SIW) utilize metal vias on a dielectric substrate to realize the field propagation mode of a waveguide, and have advantages such as low loss, low radiation, and high-quality factor. In some embodiments, at least one of the first transmission line and the second transmission line can be a strip line, a coplanar waveguide, or a substrate integrated waveguide.

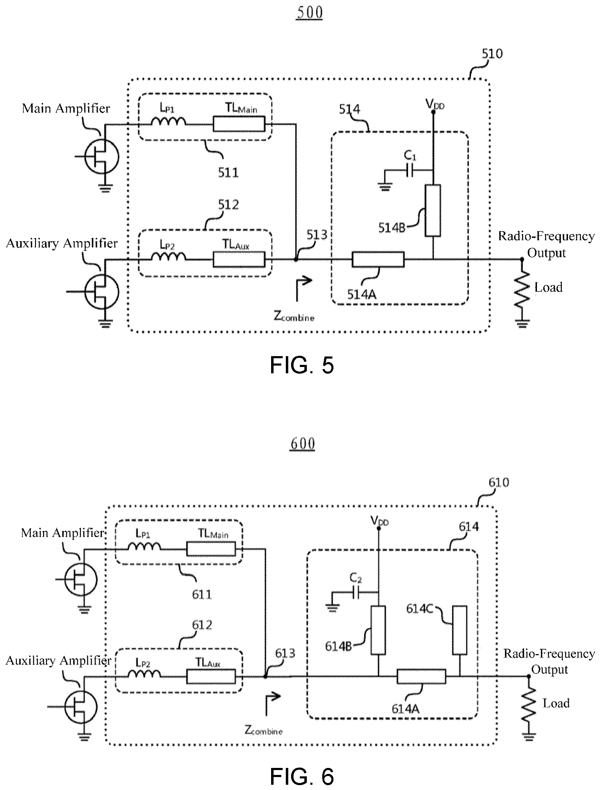

FIG. 5 schematically illustrates an exemplary schematic diagram of a merging matching network 514 according to some embodiments of the present disclosure. In some embodiments of the present disclosure, the merging matching network is configured to enable the node impedance to be present in a complex form.

As shown in FIG. 5, the merging matching network 514 comprises a third transmission line 514A, a fourth transmission line 514B, and a first capacitor $C_1$. The third transmission line 514A is connected between a combining node 513 and an output end of the merging matching network 514, and the fourth transmission line 514B is connected between the output end of the merging matching network 514 and a direct current voltage terminal $V_{DD}$. One end of the first capacitor $C_1$ is connected to the direct current voltage terminal $V_{DD}$, and the other end of the first capacitor $C_1$ is grounded, the direct current voltage terminal $V_{DD}$ is configured to provide a direct current bias voltage to the main amplifier and the auxiliary amplifier via the fourth transmission line 514B, the third transmission line 514A, the first sub-output network 511, and the second sub-output network 512.

By way of example, the third transmission line 514A and the fourth transmission line 514B can be implemented by microstrip lines. The characteristic parameters of the third transmission line 514A, the fourth transmission line 514B, and the first capacitor $C_1$ can be set to adjust the node impedance $Z_{combine}$ at the combining node 513, thereby facilitating the impedance matching described above to optimize various performance indicators of the Doherty amplifier (see the description above regarding FIG. 4A and FIG. 4B). In addition, the first capacitor $C_1$ can prevent radio-frequency signals from entering the direct current power supply line via the fourth transmission line 514B and can reduce or even avoid radio-frequency power loss in the merging matching network 514. In conventional Doherty amplifiers, the main amplifier and the auxiliary amplifier each have a corresponding direct current bias circuit (see $V_{DD1}$ and $V_{DD2}$ in FIG. 1A). In the technical scheme of this embodiment of the present disclosure, the main amplifier and the auxiliary amplifier share a direct current bias circuit, which can be integrated in the merging matching network 514. That is, the direct current voltage terminal $V_{DD}$ provides a direct current bias voltage to the main amplifier and the auxiliary amplifier via the fourth transmission line 514B, the third transmission line 514A, the first sub-output network 511, and the second sub-output network 512, thereby further reducing the circuit size of the Doherty amplifier.

FIG. 6 schematically illustrates an exemplary schematic diagram of a merging matching network 614 according to some embodiments of the present disclosure. As shown in FIG. 6, the merging matching network 614 comprises a fifth transmission line 614A, a sixth transmission line 614B, a seventh transmission line 614C, and a second capacitor $C_2$. The fifth transmission line 614A is connected between a combining node 613 and an output end of the merging matching network 614. The sixth transmission line 614B is connected between the combining node 613 and a direct current voltage terminal $V_{DD}$. One end of the seventh transmission line 614C is connected to the output end of the merging matching network 614, and the other end of the seventh transmission line 614C is floating. One end of the second capacitor $C_2$ is connected to the direct current voltage terminal $V_{DD1}$ and the other end of the second capacitor is grounded. The direct current voltage terminal $V_{DD}$ is configured to provide a direct current bias voltage to the main amplifier and the auxiliary amplifier via the sixth transmission line 614B, the first sub-output network 611, and the second sub-output network 612.

By way of example, similar to the description of FIG. 5 above, in the merging matching network 614 according to embodiments of the present disclosure, the fifth transmission line 614A, the sixth transmission line 614B, and the seventh transmission line 614C can be implemented by microstrip lines. The characteristic parameters of the fifth transmission line 614A, the sixth transmission line 614B, the seventh transmission line 614C, and the second capacitor $C_2$ can be set to adjust the node impedance $Z_{combine}$ at the combining node 613, thereby facilitating the impedance matching described above to optimize various performance indicators of the Doherty amplifier (see the description of FIG. 4A and FIG. 4B above). Particularly, compared to the relative positions of the third transmission line 514A, the fourth transmission line 514B, and the combining node 513 in FIG. 5, in the embodiment of FIG. 6, the sixth transmission line 614B connected to the direct current voltage terminal $V_{DD}$ is closer to the combining node 613. This can further reduce the baseband impedance of the Doherty amplifier and enhance the linearity of the Doherty amplifier under broadband signals. In addition, it also helps improve digital predistortion friendliness (i.e., the output signal after digital predistortion processing has minimal nonlinear distortion) for modulation signals with a higher peak-to-average power ratio and a larger bandwidth.

Furthermore, the second capacitor $C_2$ can prevent radio-frequency signals from entering the direct current power supply line via the sixth transmission line 614B and can reduce or even avoid radio-frequency power loss in the merging matching network 614. In conventional Doherty amplifiers, the main amplifier and the auxiliary amplifier each have a corresponding direct current bias circuit (see $V_{DD1}$ and $V_{DD2}$ in FIG. 1A). In this embodiment, the main amplifier and the auxiliary amplifier share a common direct current bias circuit, which can be integrated in the merging matching network 614 provided in the present disclosure. That is, the direct current voltage terminal $V_{DD}$ provides a direct current bias voltage to the main amplifier and the auxiliary amplifier via the sixth transmission line 614B, the first sub-output network 611, and the second sub-output network 612, thereby further reducing the circuit size of the Doherty amplifier.

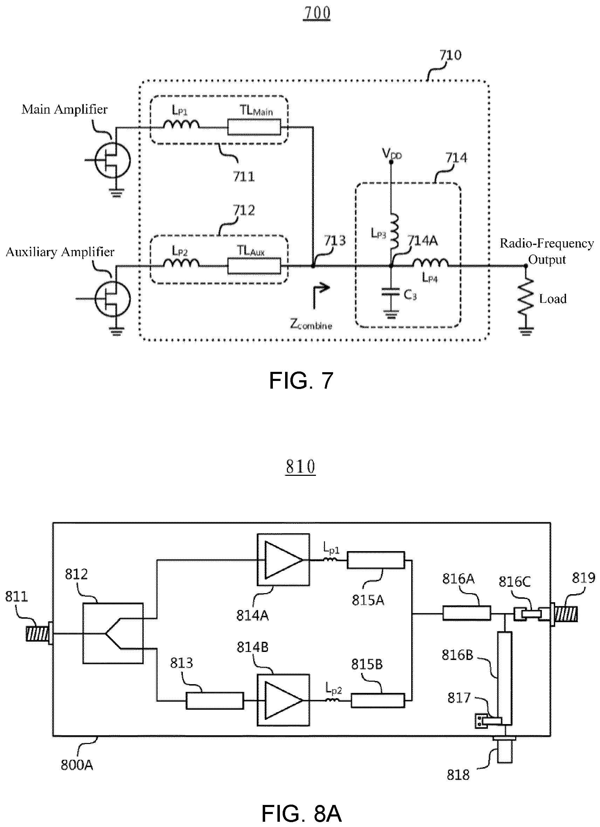

FIG. 7 schematically illustrates an exemplary schematic diagram of a merging matching network 714 according to some embodiments of the present disclosure. As shown in FIG. 7, the merging matching network 714 comprises a third inductor $L_{P3}$, a fourth inductor $L_{P4}$, and a third capacitor $C_3$. The third inductor $L_{P3}$ and the third capacitor $C_3$ are connected in series between a direct current voltage terminal $V_{DD}$ and a ground terminal. A combining node 713 is connected to a connection point between the third inductor $L_{P3}$ and the third capacitor $C_3$. The fourth inductor $L_{P4}$ is connected between the connection point between the third inductor $L_{P3}$ and the third capacitor $C_3$ and an output end of the merging matching network 714. The direct current voltage terminal $V_{DD}$ is configured to provide a current voltage bias voltage to the main amplifier and the auxiliary amplifier via the third inductor $L_{P3}$, the first sub-output network 711, and the second sub-output network 712.

By way of example, by setting the characteristic parameters (inductance value, capacitance value) of the third inductor $L_{P3}$, the fourth inductor $L_{P4}$, and the third capacitor $C_3$, the node impedance $Z_{combine}$ at the combining node 713 can be adjusted, thereby facilitating the impedance matching described above to optimize various performance indicators of the Doherty amplifier (see the description of FIG. 4A and FIG. 4B above). In addition, the third capacitor $C_3$ can prevent radio-frequency signals from entering the direct current power supply line and reduce or even avoid radio-frequency power loss in the merging matching network 714. In conventional Doherty amplifiers, the main amplifier and the auxiliary amplifier each have a corresponding direct current bias circuit (see $V_{DD1}$ and $V_{DD2}$ in FIG. 1A), while in the present disclosure, the main amplifier and the auxiliary amplifier share a common current direct bias circuit, which can be integrated into the merging matching network 714 provided in the present disclosure. That is, the direct current voltage terminal $V_{DD}$ provides a direct current bias voltage to the main amplifier and the auxiliary amplifier via the third inductor $L_{P3}$, the first sub-output network 711, and the second sub-output network 712, thereby further reducing the circuit size of the Doherty amplifier.

In the embodiments described above with reference to FIG. 5, FIG. 6, and FIG. 7, a direct current bias circuit is integrated in the merging matching network, but this is not necessary, and the number of the direct current bias circuits and their location in the Doherty amplifier circuit can be adjusted according to the actual disclosure. By way of example, when the configuration parameters of the main amplifier and the auxiliary amplifier are different (e.g., when they are not the same type of transistor), corresponding direct current bias circuits may be provided for the main amplifier and the auxiliary amplifier, respectively.

In some embodiments, the merging matching network described above with reference to FIG. 5, FIG. 6, and FIG. 7 further comprises an output capacitor. The output capacitor is connected between the output end of the merging matching network and the radio-frequency output end of the Doherty amplifier, and is configured to block the direct current signal from the direct current voltage terminal from being transmitted to the radio-frequency output end of the Doherty amplifier. By using the output capacitor, the direct current signal from the direct current voltage terminal is not transmitted to the radio-frequency output end of the Doherty amplifier, thereby protecting sensitive radio-frequency elements (load) from the influence of direct current voltage.

In another embodiment of the present disclosure, a Doherty amplifier is provided. The Doherty amplifier comprises a main amplifier, an auxiliary amplifier, and one of the output networks described above according to any embodiment of the present disclosure, and the output network is configured to receive a first amplified signal output from the main amplifier and a second amplified signal output from the auxiliary amplifier, so as to combine the first amplified signal and the second amplified signal at a combining node to be provided to the radio-frequency output end of the Doherty amplifier. Since the Doherty amplifier comprises the output network according to any embodiment of the present disclosure, the Doherty amplifier has the advantages brought by the corresponding output network.

By way of example, when the output network of the Doherty amplifier comprises the merging matching network 514 described with reference to FIG. 5, the impedance $Z_{combine}$ at the combining node 513 can be adjusted by setting the characteristic parameters of the third transmission line 514A, the fourth transmission line 514B, and the first capacitor $C_1$, thereby facilitating the impedance matching described above to optimize various performance indicators of the Doherty amplifier (see the description of FIG. 4A and FIG. 4B above). In addition, as mentioned above, the first capacitor $C_1$ can block the radio-frequency signal from entering the power supply line via the fourth transmission line 514B, and can reduce or even avoid the radio-frequency power loss in the merging matching network 514. Furthermore, in this case, the main amplifier and the auxiliary amplifier can share the direct current bias circuit integrated in the merging matching network 514, thereby further reducing the circuit size of the Doherty amplifier. An example of a Doherty amplifier based on this circuit configuration can be referred to Doherty Amplifier 810 described below with respect to FIG. 8A.

FIG. 8A schematically illustrates an exemplary layout of some components in the Doherty amplifier 810 according to some embodiments of the present disclosure. The Doherty amplifier 810 is a two-path Doherty amplifier based on LDMOS or GaN process transistors, with matching components on the peripheral printed circuit board 800A. The Doherty Amplifier 810 comprises a carrier signal input path that provides a carrier signal to the main amplifier to generate a first amplified signal and a peak signal input path that provides a peak signal to the auxiliary amplifier to generate a second amplified signal, and the Doherty Amplifier 810 comprises a phase delay member 813 located in at least one of the carrier signal input path and the peak signal input path, which is configured to form a phase difference between the carrier signal provided to the main amplifier and the peak signal provided to the auxiliary amplifier, the phase difference being less than 90 degrees.

In this embodiment, the Doherty amplifier 810 comprises a packaged main amplifier chip 814A and a packaged auxiliary amplifier chip 814B. The phase delay member 813 can be implemented as a microstrip line. The Doherty amplifier 810 also comprises a power splitter 812, which is electrically connected to the radio-frequency signal input end 811 of the Doherty amplifier 810. The first sub-output network is implemented as a series circuit of the first inductor $L_{P1}$ and the first microstrip line 815A, and the second sub-output network is implemented as a series circuit of the second inductor $L_{P2}$ and the second microstrip line 815B. The merging matching network comprises a microstrip line 816A, a microstrip line 816B, and a surface mount device (SMD) capacitor 817, which correspond to the third transmission line 514A, the fourth transmission line 514B, and the first capacitor $C_1$ described above with reference to FIG. 5, and their interconnections are consistent with the description above with reference to FIG. 5. 818 represents a direct current voltage terminal for receiving a direct current voltage signal, and surface mount device (SMD) capacitor 816C is a direct current blocking capacitor. The radio-frequency signal output end of the Doherty amplifier 810 is shown as 819. The specific implementation of the phase delay member 813 is not limited herein, and the phase delay member 813 comprises, but is not limited to, a microstrip line. Although in FIG. 8A, the phase delay member is shown in the input path of the peak amplifier 814B, alternatively, the phase delay member can also be set in the input path of the main amplifier or in both the input paths of the main amplifier and the auxiliary amplifier. In other words, those skilled in the art can implement a phase difference of less than 90 degrees between the carrier signal provided to the main amplifier and the peak signal provided to the auxiliary amplifier in different ways.

As previously described, according to some embodiments of the present disclosure, the merging matching network is configured to enable the node impedance to be present in a complex form. The phase delay member 813 forms a phase difference of less than 90 degrees between the carrier signal provided to the main amplifier and the peak signal provided to the auxiliary amplifier, which further improves the efficiency of the main amplifier and the auxiliary amplifier in the case of the impedance in a complex form at the nodes.

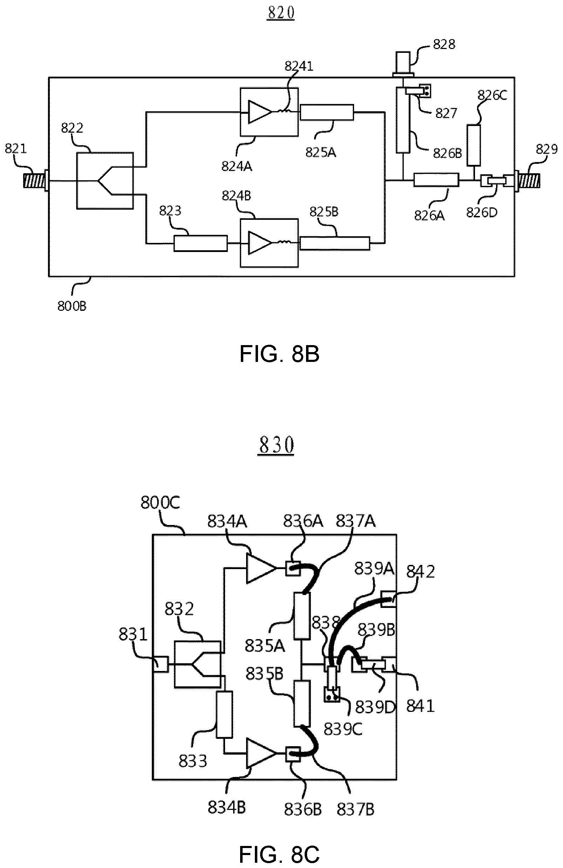

FIG. 8B illustrates an exemplary circuit configuration of a Doherty amplifier 820 according to some embodiments of the present disclosure. Similar to the Doherty amplifier 810 described in FIG. 8A, as shown in FIG. 8B, the Doherty amplifier 820 is a two-path Doherty amplifier formed based on LDMOS or GaN process transistors, with matching components on the peripheral printed circuit board 800B. The Doherty amplifier 820 comprises a carrier signal input path that provides a carrier signal to the main amplifier to generate a first amplified signal, and a peak signal input path that provides a peak signal to the auxiliary amplifier to generate a second amplified signal, and the Doherty amplifier 820 comprises a phase delay member (e.g., a microstrip line 823 shown in FIG. 8B) located in at least one of the carrier signal input path and the peak signal input path, which is configured to form a phase difference between the carrier signal provided to the main amplifier and the peak signal provided to the auxiliary amplifier, the phase difference being less than 90 degrees.

Unlike the Doherty amplifier 810 described in FIG. 8A, in the Doherty amplifier 820, the main amplifier and the first inductor (e.g., inductor 8241 shown in FIG. 8B) are located in the same package 824A, and the auxiliary amplifier and the second inductor are located in the same package 824B. The first sub-output network comprises a microstrip line 825A and an inductor 8241 in series with the main amplifier in the package, and the second sub-output network comprises a microstrip line 825B and another inductor in series with the auxiliary amplifier in the package. The merging matching network comprises a microstrip line 826A, a microstrip line 826B, a microstrip line 826C, and a surface mount device (SMD) capacitor 827, which correspond to the fifth transmission line 614A, the sixth transmission line 614B, the seventh transmission line 614C, and the second capacitor $C_2$ described above with reference to FIG. 6. 828 represents a direct current voltage terminal, and the SMD capacitor 826D is a direct current blocking capacitor. The radio-frequency input end and the radio-frequency output end of the Doherty amplifier 820 are 821 and 829, respectively. Microstrip line 826B connected to the direct current voltage terminal 828 is closer to the combining node, which further reduces the baseband impedance of the Doherty amplifier and enhances its linearity under broadband signals. Furthermore, since the main amplifier 824A and the auxiliary amplifier 824B are respectively packaged with their corresponding inductors, the integration of components is further improved, and the circuit size of the Doherty amplifier 820 is further reduced.

FIG. 8C schematically illustrates an exemplary circuit configuration of a Doherty amplifier 830 according to some embodiments of the present disclosure. As shown in FIG. 8C, the Doherty amplifier 830 is formed on an LGA substrate. The Doherty amplifier 830 is a monolithic microwave integrated circuit (MMIC) based on LDMOS or GaN technology, encapsulated within an LGA substrate package 800C. The main difference between the Doherty amplifier 830 and the Doherty amplifiers in FIG. 8A and FIG. 8B is that the circuit components on the printed circuit board are integrated onto the LGA substrate to further enhance integration. The main amplifier 834A and the auxiliary amplifier 834B are both unpackaged bare dies (comprising only parasitic capacitance), and their outputs are respectively connected to a microstrip line 835A and a microstrip line 835B via a bonding wire 837A and a bonding wire 837B, which correspond to the first inductor $L_{P1}$ and the second inductor $L_{P2}$ described in the previous embodiments. The microstrip line 835A and the microstrip line 835B correspond to the first transmission line in the first sub-output network and the second transmission line in the second sub-output network described in the previous embodiments. 836A and 836B are output bonding pads on the bare dies. The microstrip line 833, the microstrip line 835A, and the microstrip line 835B can be implemented using a high dielectric constant substrate to reduce the overall circuit area. The merging matching network is formed by an inductor 839A, an inductor 839B, and a capacitor 839C, which correspond to the third inductor $L_{P3}$, the fourth inductor $L_{P4}$, and the third capacitor $C_3$ described above with respect to FIG. 7. These capacitors can be implemented using metal-oxide-metal capacitors, edge capacitors, or surface mount device (SMD) capacitors, and the third inductor and the fourth inductor can be implemented using bonding wires. The bonding wires are also connected to drain voltage terminals via pin pad 842. The pin pad 831 and the pin pad 841 represent the radio-frequency signal input end and radio-frequency signal output end of the Doherty amplifier, respectively.

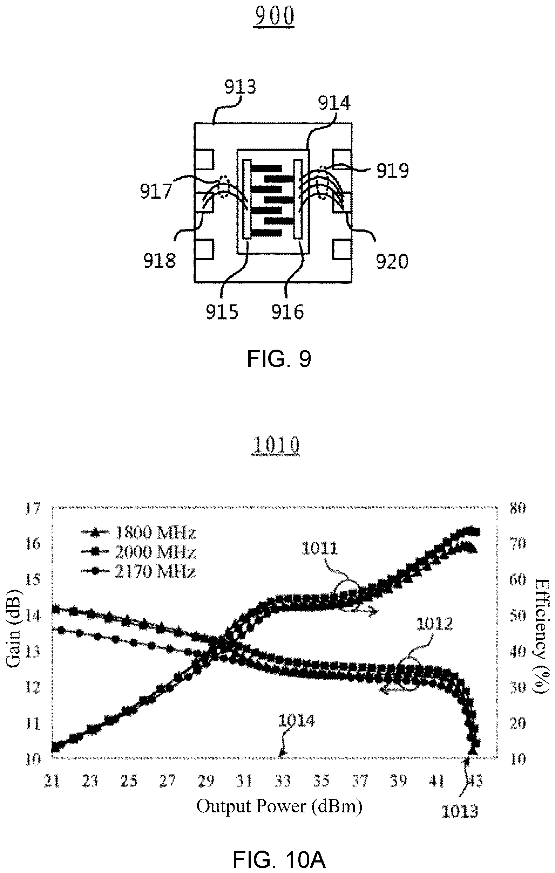

In the above embodiments of the present disclosure, the first inductor $L_{P1}$ and the second inductor $L_{P2}$ can be implemented using bonding wires. FIG. 9 schematically illustrates an exemplary circuit structure of the first inductor $L_{P1}$ and the second inductor $L_{P2}$ according to some embodiments of the present disclosure.

As shown in FIG. 9, 913 is a transistor (main amplifier or auxiliary amplifier) QFN package shell, 914 is a transistor chip bare die, 915 is a gate bonding pad, which is connected to the input pin 918 of the chip via bonding wire 917, and 916 is a drain bonding pad, which is connected to the output pin 920 of the chip via a plurality of bonding wires 919. In some embodiments, the plurality of bonding wires 919 can be connected in parallel to each other, and the equivalent inductance value of the first inductor $L_{P1}$ and the second inductor $L_{P2}$ can be conveniently adjusted by adjusting the number, the length, the height, and other parameters of the bonding wires 919, thereby helping to optimize various performance indicators of the amplifier.

Of course, the specific implementation of the first inductor and the second inductor are not limited to bonding wires. In other embodiments, the first inductor and the second inductor mentioned above can also be realized by means of microstrip lines, and no special restrictions are made on the specific forms of the first inductor and the second inductor herein.

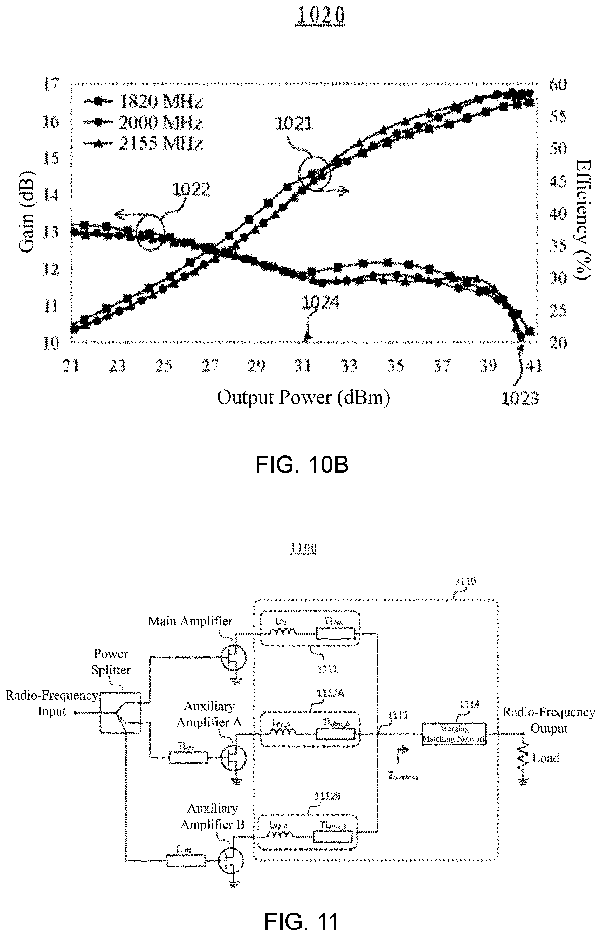

FIG. 10A and FIG. 10B schematically show exemplary diagrams of performance of a Doherty amplifier according to some embodiments of the present disclosure obtained through simulation experiments. In this embodiment, the center operating frequency of the Doherty amplifier is 2 GHz, with a total output power of 16 W. The output capacitance (drain parasitic capacitance of the transistors) of the main amplifier and the auxiliary amplifier are 1.02 pF, and the inductance values of the first inductor and the second inductor are 0.25 pF. The characteristic impedance of the first transmission line is 53 Ohm with an electrical angle of 44.7°, and the characteristic impedance of the second transmission line is 37.5 Ohm with an electrical angle of 80.9°. The merging matching network presents an impedance (14.23-j5.89) Ohm in a complex form at the node impedance $Z_{combine}$. The electrical angle of the phase delay member is 37.76°. FIG. 10A corresponds to the Doherty amplifier 820 shown in FIG. 8B, and FIG. 10B corresponds to the Doherty amplifier 830 shown in FIG. 8C.

As shown in FIG. 10A, between the operating frequencies of 1800 MHz and 2170 MHz, curve 1011 indicates the efficiency of the Doherty amplifier 820 as a function of output power, and curve 1012 indicates the gain of the Doherty amplifier 820 as a function of output power. It can be seen that the Doherty amplifier 820 can achieve a saturation output power of over 42 dBm (1013) and maintain high efficiency under 10 dB back-off power (1014), that is, the back-off power range of the Doherty amplifier 820 is around 10dB.

As shown in FIG. 10B, between the operating frequencies of 1820 MHz and 2155 MHz, curve 1021 indicates the efficiency of the Doherty amplifier 830 as a function of output power, and curve 1022 indicates the gain of the Doherty amplifier 830 as a function of output power. Due to the larger losses generated by the LGA substrate and elements used in the Doherty amplifier 830, the efficiency shown in FIG. 10B is slightly lower compared to FIG. 10A (but the Doherty amplifier 830 has higher integration and smaller circuit size). As can be seen from the FIG. 10B, the Doherty amplifier 830 can achieve a saturation output power of over 40 dBm (1023) and maintain high efficiency under 10 dB power back-off (1024), that is, the power back-off range of the Doherty amplifier 830 is around 10 dB.

According to the embodiments described in this disclosure, in the embodiments of the Doherty amplifier described above, both the main amplifier and the auxiliary amplifier comprise transistors. A first characteristic impedance $Z_{Main}$ of the first transmission line, a first electrical angle $\theta_{Main}$ of the first transmission line, a second characteristic impedance $Z_{Aux}$ of the second transmission line, and the second electrical angle $\theta_{Aux}$ of the second transmission line are as follows:

$$Z_{Main} = \frac{\sin\theta_{IN} \cdot R_{opt}}{\sqrt{\alpha x} \cdot \sin\theta_{Main}} - \omega \cdot L_{P1} \cdot \cot\theta_{Main} \qquad \text{Equation 1}$$

$$Z_{Aux} = \frac{(1+\alpha) \cdot \sin\theta_{IN} \cdot \cos\theta_{IN} \cdot R_{opt}}{\sqrt{\alpha x} \cdot \sin\theta_{Aux}} - \omega \cdot L_{P2} \cdot \cot\theta_{Aux} \qquad \text{Equation 2}$$

$$\theta_{Main} = \cos^{-1}\left[\frac{\sin\theta_{IN} \cdot \omega \cdot C_{DS} \cdot R_{opt} + \alpha \cdot \cos\theta_{IN}}{\sqrt{\alpha x}}\right] \qquad \text{Equation 3}$$

$$\theta_{Aux} = \cos^{-1}\left[\frac{(1-2\alpha) \cdot \tan\theta_{IN} \cdot \omega \cdot C_{DS} \cdot R_{opt} - \alpha}{(1-\alpha) \cdot \sqrt{\alpha x}}\right] \qquad \text{Equation 4}$$

Where $\theta_{IN}$ represents the phase difference (less than 90 degrees) between the carrier signal provided to the main amplifier and the peak signal provided to the auxiliary amplifier (the phase difference is greater than 0 degrees), $\omega$ is the center operating frequency of the Doherty amplifier, $R_{opt}$ is the optimal operating load of the transistor, $L_{P1}$ represents a first inductance value of the first inductor, $L_{P2}$ represents a second inductance value of the second inductor, $C_{DS}$ is the drain parasitic capacitance of the transistor, $\alpha$ represents the power level at which the auxiliary amplifier is turned on, and x is a constant. $\alpha$, which represents the power level at which the auxiliary amplifier is turned on, is relative to the maximum power value. Therefore, in some embodiments, $\alpha$ can be considered as the ratio of the power at which the auxiliary amplifier is turned on to the maximum power. From the above equations, it can be seen that the constant x and the inductance value of the first inductor and the inductance value of the second inductor can affect the first characteristic impedance $Z_{Main}$ of the first transmission line, the first electrical angle $\theta_{Main}$ of the first transmission line, the second characteristic impedance $Z_{Aux}$ of the second transmission line, and the second electrical angle $\theta_{Aux}$ of the second transmission line, thereby affecting the size parameters of the first transmission line and the second transmission line. By selecting the appropriate constant x and inductance value of the first inductor and inductance value of the second inductor, the first transmission line and the second transmission line suitable for manufacturing can be implemented. The term "optimal working load" mentioned herein refers to the load impedance that allows the amplifier (the main amplifier or the auxiliary amplifier) to achieve the highest efficiency at a specific power level. However, the load impedance does not consider the parasitic parameters of the transistor (such as the drain parasitic capacitance $C_{DS}$). In other words, the $R_{opt}$ mentioned above is the optimal operating load of the transistor after removing the parasitic parameters. Therefore, the optimal operating load is usually a real number.

In some embodiments according to the present disclosure, the phase difference $\theta_{IN}$ in equations 1-4 satisfies:

$$\theta_{IN} = \tan^{-1}\left[\sqrt{\frac{\alpha \cdot (2 - \alpha)}{(1 - 2\alpha)}}\right]$$

, where $\alpha$ is greater than 0 and less than 0.5, where $1 \leq x \leq 10$.

In some embodiments according to the present disclosure, the node impedance $Z_{combine}$ at the combining node satisfies the following equations:

$$\frac{1}{Z_{combine}} = \frac{x}{R_{opt}} + j\frac{\cos\theta_{Main} - (\omega \cdot L_{P1} \cdot \sin\theta_{Main})/Z_{Main} - \delta}{Z_{Main} \cdot \sin\theta_{Main} + \omega \cdot L_{P1} \cdot \cos\theta_{Main}} \qquad \text{Equation 5}$$

$$\delta = \frac{\dfrac{\omega \cdot L_{P2} \cdot \sin\theta_{Aux}}{Z_{Aux}} - \sqrt{\dfrac{x}{\alpha} \cdot \dfrac{\alpha^2}{1-\alpha}} - \cos\theta_{Aux}}{(1+\alpha) \cdot \cos\theta_{IN}} \qquad \text{Equation 6}$$

Based on the obtained node impedance $Z_{combine}$, a properly designed merging matching network can be constructed. The specific examples of the merging matching network described in reference to FIG. 5 to FIG. 8C are merely illustrative and do not limit the merging matching network. Various specific configurations of the merging matching network can be designed and implemented based on the node impedance $Z_{combine}$.

Fig. 11 schematically illustrates an exemplary schematic diagram of a Doherty Amplifier 1100 according to another embodiment of the present disclosure. As shown in FIG. 11, the Doherty amplifier 1100 comprises a plurality of auxiliary amplifiers (such as an auxiliary amplifier A and an auxiliary amplifier B shown in FIG. 11). The output network 1110 comprises a plurality of second sub-output networks (such as the second sub-output network 1112A and the second sub-output network 1112B shown in FIG. 11) corresponding to the auxiliary amplifier A and the auxiliary amplifier B, respectively. The first sub-output network 1111 is configured to receive the first amplified signal from the output of the main amplifier, and the second sub-output network 1112A and the second sub-output network 1112B are respectively configured to receive the second amplified signals from the output of the auxiliary amplifier A and the auxiliary amplifier B. The first amplified signal and the second amplified signal output from each auxiliary amplifier are combined at a combining node 1213 to provide a radio-frequency output end to the Doherty amplifier 1100. It should be noted that although FIG. 11 shows that the Doherty amplifier 1100 comprises two auxiliary amplifiers, this does not constitute a limitation on the structure of the Doherty Amplifier. The Doherty amplifier can comprise more auxiliary amplifiers (e.g., three, four, or more auxiliary amplifiers), that is, the Doherty amplifier can be a multi-path Doherty amplifier comprising a plurality of amplification paths. The multi-path Doherty amplifier comprising the output network described in the above embodiments can provide a larger operating bandwidth and deeper back-off power, which will not be described herein.

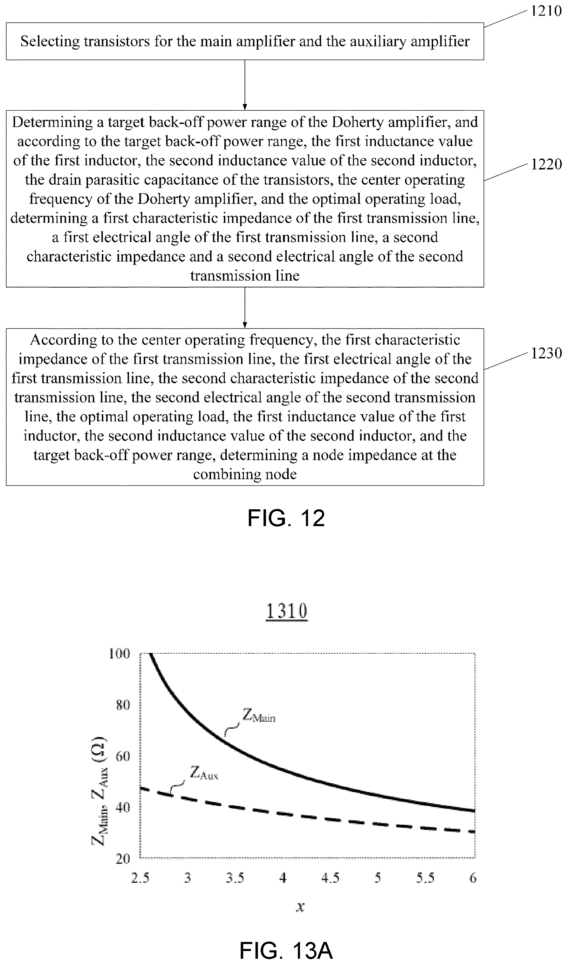

Another embodiment of the present disclosure provides a method for designing a Doherty amplifier. The Doherty amplifier comprises a main amplifier, at least one auxiliary amplifier, and the output network 310 described above with reference to FIG. 3. FIG. 12 schematically illustrates a flowchart 1200 of a method for designing a Doherty amplifier according to some embodiments of the present disclosure. As shown in FIG. 12, the method comprises the following steps:

Step 1210: selecting transistors for the main amplifier and the auxiliary amplifier. The selection of transistors can consider various design requirements, such as power, cost, size, etc. Reference can be made to the description of different types of transistors mentioned above, and the present disclosure does not limit this. With the transistors for the amplifier determined, the optimal operating load $R_{opt}$ of the transistors can also be determined; Step 1220: determining a target back-off power range of the Doherty amplifier, and according to the target back-off power range, the first inductance value of the first inductor, the second inductance value of the second inductor, the drain parasitic capacitance of the transistors, the center operating frequency of the Doherty amplifier, and the optimal operating load, determining a first characteristic impedance of the first transmission line, a first electrical angle of the first transmission line, a second characteristic impedance and a second electrical angle of the second transmission line; Step 1230: according to the center operating frequency, the first characteristic impedance of the first transmission line, the first electrical angle of the first transmission line, the second characteristic impedance of the second transmission line, the second electrical angle of the second transmission line, the optimal operating load, the first inductance value of the first inductor, the second inductance value of the second inductor, and the target back-off power range, determining a node impedance at the combining node.

Therefore, the embodiments of the present disclosure propose a method for designing a Doherty amplifier according to the desired target back-off power range, with the goal of simplifying the configuration of the output network of the Doherty amplifier and achieving coordination and unity between extending the back-off power range of the Doherty amplifier and simplifying the circuit configuration of the Doherty amplifier. In other words, by using the method for designing a Doherty amplifier proposed in the embodiments of the present disclosure, a more compact Doherty amplifier with a simplified circuit configuration can be obtained. In addition, the Doherty amplifier can also achieve efficient work within a low power to high power range, with deeper back-off power and wider operating bandwidth.

According to some embodiments of the present disclosure, the step of according to the target back-off power range, the first inductance value of the first inductor, the second inductance value of the second inductor, the drain parasitic capacitance of the transistors, the center operating frequency of the Doherty amplifier, and the optimal operating load, determining a first characteristic impedance of the first transmission line, a first electrical angle of the first transmission line, a second characteristic impedance and a second electrical angle of the second transmission line comprises: respectively calculating a first characteristic impedance $Z_{Main}$, a first electrical angle $\theta_{Main}$ of the first transmission line, a second characteristic impedance $Z_{Aux}$ and a second electrical angle $\theta_{Aux}$ of the second transmission line, via the following equations:

$$Z_{Main} = \frac{\sin\theta_{IN} \cdot R_{opt}}{\sqrt{\alpha x} \cdot \sin\theta_{Main}} - \omega \cdot L_{P1} \cdot \cot\theta_{Main}$$

$$Z_{Aux} = \frac{(1+\alpha) \cdot \sin\theta_{IN} \cdot \cos\theta_{IN} \cdot R_{opt}}{\sqrt{\alpha x} \cdot \sin\theta_{Aux}} - \omega \cdot L_{P2} \cdot \cot\theta_{Aux}$$

$$\theta_{Main} = \cos^{-1}\left[\frac{\sin\theta_{IN} \cdot \omega \cdot C_{DS} \cdot R_{opt} + \alpha \cdot \cos\theta_{IN}}{\sqrt{\alpha x}}\right]$$

$$\theta_{Aux} = \cos^{-1}\left[\frac{(1-2\alpha) \cdot \tan\theta_{IN} \cdot \omega \cdot C_{DS} \cdot R_{opt} - \alpha}{(1-\alpha) \cdot \sqrt{\alpha x}}\right],$$

$\theta_{IN}$ represents the phase difference, $\omega$ is the center operating frequency of the Doherty amplifier, $R_{opt}$ is the optimal operating load of the transistor, $L_{P1}$ represents the first inductance value of the first inductor, $L_{P2}$ represents the second inductance value of the second inductor, $C_{DS}$ is the drain parasitic capacitance of the transistor, $\alpha$ represents the power level coefficient that enables the auxiliary amplifier to turn on, and $x$ is a constant. The step of according to the center operating frequency, the first characteristic impedance of the first transmission line, the first electrical angle of the first transmission line, the second characteristic impedance of the second transmission line, the second electrical angle of the second transmission line, the optimal operating load, the first inductance value of the first inductor, the second inductance value of the second inductor, and the target back-off power range, determining a node impedance at the combining node comprises determining a node impedance $Z_{combine}$ at the combining node via the following equations:

$$\frac{1}{Z_{combine}} = \frac{x}{R_{opt}} + j\frac{\cos\theta_{Main} - (\omega \cdot L_{P1} \cdot \sin\theta_{Main})/Z_{Main} - \delta}{Z_{Main} \cdot \sin\theta_{Main} + \omega \cdot L_{P1} \cdot \cos\theta_{Main}}$$

$$\delta = \frac{\frac{\omega \cdot L_{P2} \cdot \sin\theta_{Aux}}{Z_{Aux}} - \sqrt{\frac{x}{\alpha} \cdot \frac{\alpha^2}{1-\alpha}} - \cos\theta_{Aux}}{(1+\alpha) \cdot \cos\theta_{IN}}$$

Where the target back-off power range is $10 \cdot \log\left(\frac{2}{\alpha}\right) dB$ .

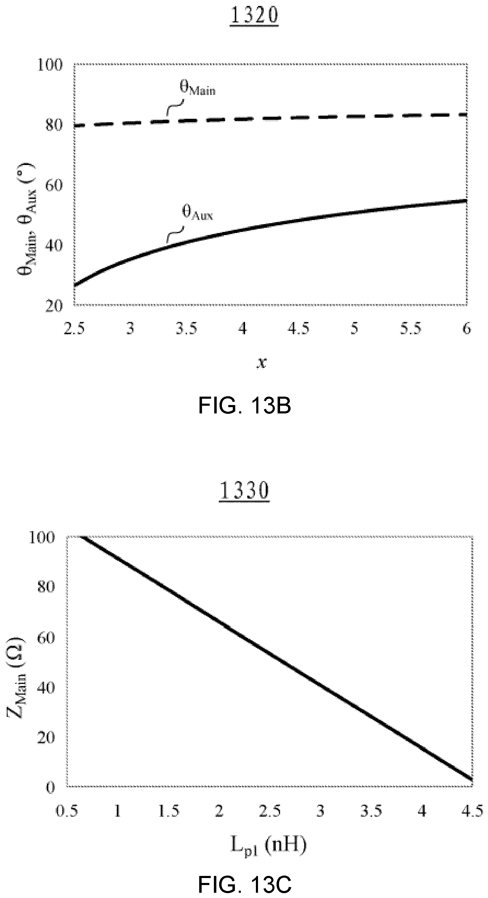

It can be understood that the constant x, the first inductance value of the first inductor, the second inductor value of the second inductor have positive practical significance for the flexibility of the design of the specific parameters of the first transmission line and the second transmission line in the output network. By selecting different values for the constant *x*, different values can be obtained for the first characteristic impedance $Z_{Main}$ of the first transmission line and the first electrical angle $\theta_{Main}$ of the first transmission line, as well as the second characteristic impedance $Z_{Aux}$ of the second transmission line and the second electrical angle $\theta_{Aux}$ of the second transmission line. FIG. 13A and FIG. 13B schematically illustrate examples of the values of the characteristic impedance and electrical angle of the first transmission line and the second transmission line according to some embodiments of the present disclosure, as shown in Figure 1310 and Figure 1320. Taking the design case "the center operating frequency is 2 GHz, the optimal operating load $R_{opt}$=60 Ohm, the back-off power range=9 dB, $L_{P1}=L_{P2}$=0.3 nH, the drain parasitic capacitance $C_{DS}$=1 pF" as an example, the selection of the constant *x* can be used to adjust the characteristic impedance of the transmission line within a manufacturable range (30-100 Ohm), and at the same time, the constant *x* can be used to adjust the electrical angle of the transmission line to achieve a smaller circuit size (i.e., a smaller electrical angle corresponds to a smaller size of the transmission line).

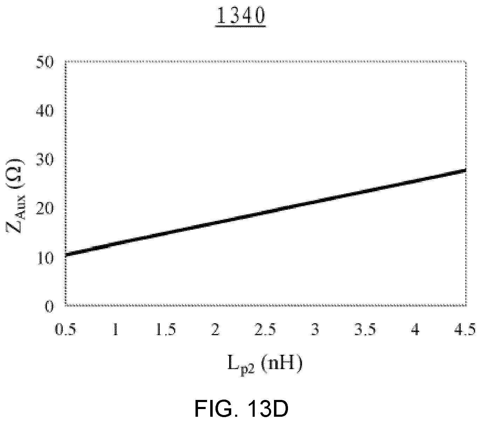

FIG. 13C schematically illustrates an example of the relationship between the first characteristic impedance of the first transmission line and the first inductance value of the first inductor according to some embodiments of the present disclosure, as shown in Figure 1330. Taking the design case "the center operating frequency is 2 GHz, the optimal operating load $R_{opt}$=60 Ohm, the back-off power range=9 dB, $L_{P1}=L_{P2}$=0.3 nH, $C_{DS}$=1 pF, x=2.5" as an example (where $R_{opt}$=60 Ohm corresponds to the small power amplifiers and the medium power amplifiers), if the main path does not comprise the first inductor described in some embodiments of present disclosure, even considering the parasitic inductance of the transistor in the main amplifier (<0.5 pF), the first characteristic impedance $Z_{main}$ of the first transmission line will be much greater than 100 Ohm, which is difficult to achieve in the specific implementation of the first transmission line. As shown in FIG. 13C, by increasing $L_{P1}$, $Z_{main}$ can be reduced, which helps to achieve the characteristic impedance of the transmission line that meets the design requirements. FIG. 13D schematically illustrates an example of the relationship between the second characteristic impedance of the second transmission line and the second inductance value of the second inductor according to some embodiments of the present disclosure, as shown in Figure 1340. Taking the design case "the center operating frequency 2 GHz, the optimal operating load $R_{opt}$=10 Ohm, the back-off power range=9 dB, $L_{P1}=L_{P2}$=0.3 nH, $C_{DS}$=1 pF, x=2.5" as an example (wherein $R_{opt}$=10 Ohm corresponds to the high power amplifiers design scenario), if the auxiliary path does not comprise the second inductor, even considering the parasitic inductance of the transistor in the auxiliary amplifier (<0.5 pF), $Z_{Aux}$ will be less than 10 Ohm, which is also difficult to achieve in the practical design of the second transmission line. As shown in FIG. 13D, by increasing $L_{P2}$, $Z_{AUX}$ can be increased, which helps to achieve the characteristic impedance of the second transmission line that meets the design requirements.

Therefore, by using the constant *x*, the first inductor, and the second inductor, greater flexibility can be provided for the design of the first transmission line and the second transmission line in the output network, and it can also guarantee the ease of manufacture of the first transmission line and the second transmission line.

It is understood that although terms such as "first," "second," "third", etc., may be used herein to describe various devices, elements, parts, or portions, these devices, elements, parts, or portions should not be limited by these terms. These terms are only used to distinguish one device, component, part, or portion from another. The term "connection" mentioned herein includes both "direct connection" and "indirect connection".

Although some embodiments have been described in conjunction with specific examples in present disclosure, it is not intended to be limited to the specific forms described herein. Instead, the scope of this disclosure is only limited by the appended claims. Additionally, although individual features may be included in different claims, it is possible that these features may be advantageously combined and the combined of features in different claims does not imply that the combination is feasible and/or advantageous. The order of features in the claims does not imply that the features must be performed in any particular order. Furthermore, in the claims, the term "comprise" does not exclude other elements, and the terms "a" or "an" do not exclude multiple. The reference numerals in the claims are provided as explicit examples and should not be interpreted as limiting the scope of the claims in any way.

**Claims**

1. An output network for a Doherty amplifier, wherein the Doherty amplifier comprises a main amplifier and an auxiliary amplifier, and the output network comprises:

   a first sub-output network corresponding to the main amplifier, a second sub-output network corresponding to the auxiliary amplifier, a combining node, and a merging matching network,
   wherein the output end of the first sub-output network and the output end of the second sub-output network are both connected to the combining node, and the merging matching network is configured to connect the combining node to the radio-frequency output end of the Doherty amplifier,
   wherein the first sub-output network comprises a first series circuit formed by a first inductor and a first transmission line connected in series, and the second sub-output network comprises a second series circuit formed by a second inductor and a second transmission line,

wherein the first series circuit is connected between the output end of the main amplifier and the combining node, the second series circuit is connected between the output end of the auxiliary amplifier and the combining node, and the first series circuit and the second series circuit are configured to enable the node impedance at the combining node to be matched to the target load impedance of the main amplifier and the auxiliary amplifier.

2. The output network according to claim 1, wherein
at least one of the first transmission line and the second transmission line is a microstrip line.

3. The output network according to claim 1, wherein
the merging matching network comprises a third transmission line, a fourth transmission line, and a first capacitor, wherein the third transmission line is connected between the combining node and the output end of the merging matching network, the fourth transmission line is connected between the output end of the merging matching network and a direct current voltage terminal, one end of the first capacitor is connected to the direct current voltage terminal, and the other end of the first capacitor is grounded, wherein the direct current voltage terminal is configured to provide a direct current bias voltage to the main amplifier and the auxiliary amplifier via the fourth transmission line, the third transmission line, the first sub-output network, and the second sub-output network.

4. The output network according to claim 1, wherein
the merging matching network comprises a fifth transmission line, a sixth transmission line, a seventh transmission line, and a second capacitor, wherein the fifth transmission line is connected between the combining node and the output end of the merging matching network, the sixth transmission line is connected between the combining node and a direct current voltage terminal, one end of the seventh transmission line is connected to the output end of the merging matching network, and the other end of the seventh transmission line is floating, one end of the second capacitor is connected to the direct current voltage terminal, and the other end of the second capacitor is grounded, wherein the direct current voltage terminal is configured to provide a direct current bias voltage to the main amplifier and the auxiliary amplifier via the sixth transmission line, the first sub-output network, and the second sub-output network.

5. The output network according to claim 1, wherein
the merging matching network comprises a third inductor, a fourth inductor, and a third capacitor, wherein the third inductor and the third capacitor are connected in series between the direct current voltage terminal and the ground terminal, the combining node is connected to the connection point between the third inductor and the third capacitor, and the fourth inductor is connected between the connection point between the third inductor and the third capacitor and the output end of the merging matching network, wherein the direct current voltage terminal is configured to provide a direct current bias voltage to the main amplifier and the auxiliary amplifier via the third inductor, the first sub-output network, and the second sub-output network.

6. The output network according to any one of claims 3 to 5, wherein
the merging matching network further comprises an output capacitor, wherein the output capacitor is connected between the output end of the merging matching network and the radio-frequency output end of the Doherty amplifier, and is configured to block the direct current signal from the direct current voltage terminal from being transmitted to the radio-frequency output end of the Doherty amplifier.

7. The output network according to claim 1, wherein
the merging matching network is configured to enable the node impedance to be present in a complex form.

8. The output network according to claim 1, wherein
at least one of the first inductor and the second inductor comprises a plurality of bonding wires.

9. The output network according to claim 1, wherein
at least one of the first inductor and the second inductor comprises a microstrip line.

10. The output network according to claim 1, wherein
at least one of the first transmission line and the second transmission line comprise a strip line, a coplanar waveguide, or a substrate integrated waveguide.

**11.** A Doherty amplifier, comprising:

a main amplifier;
an auxiliary amplifier; and
an output network according to any one of claims 1-10, wherein
the output network is configured to receive a first amplified signal output from the main amplifier and a second amplified signal output from the auxiliary amplifier, so as to combine the first amplified signal and the second amplified signal at a combining node to be provided the radio-frequency output end to the Doherty amplifier.

**12.** The Doherty amplifier according to claim 11, wherein
the Doherty amplifier comprises a carrier signal input path providing a carrier signal to the main amplifier to generate the first amplified signal, and a peak signal input path providing a peak signal to the auxiliary amplifier to generate the second amplified signal, wherein the Doherty amplifier comprises at least a phase delay member located in at least one of the carrier signal input path and the peak signal input path, wherein the phase delay member is configured to form a phase difference between the carrier signal provided to the main amplifier and the peak signal provided to the auxiliary amplifier, wherein the phase difference is less than 90 degrees.

**13.** The Doherty amplifier according to claim 12, wherein
both the main amplifier and the auxiliary amplifier comprise transistors, a first characteristic impedance $Z_{Main}$ of the first transmission line, a first electrical angle $\theta_{Main}$ of the first transmission line, a second characteristic impedance $Z_{Aux}$ of the second transmission line, and the second electrical angle $\theta_{Aux}$ of the second transmission line are:

$$Z_{Main} = \frac{\sin \theta_{IN} \cdot R_{opt}}{\sqrt{\alpha x} \cdot \sin \theta_{Main}} - \omega \cdot L_{P1} \cdot \cot \theta_{Main}$$

$$Z_{Aux} = \frac{(1 + \alpha) \cdot \sin \theta_{IN} \cdot \cos \theta_{IN} \cdot R_{opt}}{\sqrt{\alpha x} \cdot \sin \theta_{Aux}} - \omega \cdot L_{P2} \cdot \cot \theta_{Aux}$$

$$\theta_{Main} = \cos^{-1} \left[ \frac{\sin \theta_{IN} \cdot \omega \cdot C_{DS} \cdot R_{opt} + \alpha \cdot \cos \theta_{IN}}{\sqrt{\alpha x}} \right]$$

$$\theta_{Aux} = \cos^{-1} \left[ \frac{(1 - 2\alpha) \cdot \tan \theta_{IN} \cdot \omega \cdot C_{DS} \cdot R_{opt} - \alpha}{(1 - \alpha) \cdot \sqrt{\alpha x}} \right]$$

wherein $\theta_{IN}$ represents the phase difference, $\omega$ is the center operating frequency of the Doherty amplifier, $R_{opt}$ is the optimal operating load of the transistor, $L_{P1}$ represents the first inductance value of the first inductor, $L_{P2}$ represents the second inductance value of the second inductor, $C_{DS}$ is the drain parasitic capacitance of the transistor, $\alpha$ represents the power level of the auxiliary amplifier turned on to operate, and x is a constant.

**14.** The Doherty amplifier according to claim 13, wherein

$$\theta_{IN} = \tan^{-1} \left[ \sqrt{\frac{\alpha \cdot (2 - \alpha)}{(1 - 2\alpha)}} \right]$$

the phase difference $\theta_{IN}$ is , wherein $\alpha$ is greater than 0 and less than 0.5, wherein $1 \leq x \leq 10$.

**15.** The Doherty amplifier according to claim 14, wherein
the node impedance $Z_{combine}$ at the combining node satisfies the following equations:

$$\frac{1}{Z_{combine}} = \frac{x}{R_{opt}} + j \frac{\cos \theta_{Main} - (\omega \cdot L_{P1} \cdot \sin \theta_{Main})/Z_{Main} - \delta}{Z_{Main} \cdot \sin \theta_{Main} + \omega \cdot L_{P1} \cdot \cos \theta_{Main}}$$

$$\delta = \frac{\dfrac{\omega \cdot L_{P2} \cdot \sin \theta_{Aux}}{Z_{Aux}} - \sqrt{\dfrac{x}{\alpha} \cdot \dfrac{\alpha^2}{1-\alpha}} - \cos \theta_{Aux}}{(1+\alpha) \cdot \cos \theta_{IN}}.$$

16. The Doherty amplifier according to claim 11, wherein
the Doherty amplifier comprises multiple auxiliary amplifiers, and the output network comprises a plurality of second sub-output networks corresponding to the plurality of auxiliary amplifiers, wherein the first sub-output network is configured to receive the first amplified signal from the output of the main amplifier, and each second sub-output network is configured to receive the second amplified signal from the corresponding auxiliary amplifier among the plurality of auxiliary amplifiers, so as to combine the first amplified signal and the second amplified signal output from each auxiliary amplifier at the combining node to be provided to a radio-frequency output to the Doherty amplifier.

17. A method for designing a Doherty amplifier, wherein the Doherty amplifier comprises a main amplifier, at least one auxiliary amplifier, and an output network as claimed in claim 1, wherein the method comprises:

selecting transistors for the main amplifier and the auxiliary amplifier;
determining a target back-off power range of the Doherty amplifier, and according to the target back-off power range, the first inductance value of the first inductor, the second inductance value of the second inductor, the drain parasitic capacitance of the transistors, the center operating frequency of the Doherty amplifier, and the optimal operating load, determining a first characteristic impedance of the first transmission line, a first electrical angle of the first transmission line, a second characteristic impedance and a second electrical angle of the second transmission line;
according to the center operating frequency, the first characteristic impedance of the first transmission line, the first electrical angle of the first transmission line, the second characteristic impedance of the second transmission line, the second electrical angle of the second transmission line, the optimal operating load, the first inductance value of the first inductor, the second inductance value of the second inductor, and the target back-off power range, determining a node impedance at the combining node.

18. The method according to claim 17, wherein
according to the target back-off power range, the first inductance value of the first inductor, the second inductance value of the second inductor, the drain parasitic capacitance of the transistors, the center operating frequency of the Doherty amplifier, and the optimal operating load, determining a first characteristic impedance of the first transmission line, a first electrical angle of the first transmission line, a second characteristic impedance and a second electrical angle of the second transmission line comprises:

respectively calculating a first characteristic impedance $Z_{Main}$ of the first transmission line, a first electrical angle $\theta_{Main}$ of the first transmission line, a second characteristic impedance $Z_{Aux}$ of the second transmission line and a second electrical angle $\theta_{Aux}$ of the second transmission line, via the following equations:

$$Z_{Main} = \frac{\sin \theta_{IN} \cdot R_{opt}}{\sqrt{\alpha x} \cdot \sin \theta_{Main}} - \omega \cdot L_{P1} \cdot \cot \theta_{Main}$$

$$Z_{Aux} = \frac{(1+\alpha) \cdot \sin \theta_{IN} \cdot \cos \theta_{IN} \cdot R_{opt}}{\sqrt{\alpha x} \cdot \sin \theta_{Aux}} - \omega \cdot L_{P2} \cdot \cot \theta_{Aux}$$

$$\theta_{Main} = \cos^{-1}\left[\frac{\sin \theta_{IN} \cdot \omega \cdot C_{DS} \cdot R_{opt} + \alpha \cdot \cos \theta_{IN}}{\sqrt{\alpha x}}\right]$$

$$\theta_{Aux} = \cos^{-1}\left[\frac{(1-2\alpha) \cdot \tan \theta_{IN} \cdot \omega \cdot C_{DS} \cdot R_{opt} - \alpha}{(1-\alpha) \cdot \sqrt{\alpha x}}\right]$$

wherein $\theta_{IN}$ represents the phase difference, $\omega$ is the center operating frequency of the Doherty amplifier, $R_{opt}$ is the optimal operating load of the transistors, $L_{P1}$ represents the first inductance value of the first inductor, $L_{P2}$

represents the second inductance value of the second inductor, $C_{DS}$ is the drain-source parasitic capacitance of the transistors, $\alpha$ represents the power level coefficient that enables the auxiliary amplifier to turn on, and $x$ is a constant; and

wherein the step of according to the center operating frequency, the first characteristic impedance of the first transmission line, the first electrical angle of the first transmission line, the second characteristic impedance of the second transmission line, the second electrical angle of the second transmission line, the optimal operating load, the first inductance value of the first inductor, the second inductance value of the second inductor, and the target back-off power range, determining a node impedance at the combining node comprises:

determining a node impedance Zcombine at the combining node via the following equations:

$$\frac{1}{Z_{combine}} = \frac{x}{R_{opt}} + j\frac{\cos\theta_{Main} - \left(\omega \cdot L_{P1} \cdot \sin\theta_{Main}\right)/Z_{Main} - \delta}{Z_{Main} \cdot \sin\theta_{Main} + \omega \cdot L_{P1} \cdot \cos\theta_{Main}}$$

$$\delta = \frac{\dfrac{\omega \cdot L_{P2} \cdot \sin\theta_{Aux}}{Z_{Aux}} - \sqrt{\dfrac{x}{\alpha} \cdot \dfrac{\alpha^2}{1-\alpha}} - \cos\theta_{Aux}}{(1+\alpha)\cdot\cos\theta_{IN}}$$

wherein the target back-off power range is $10 \cdot \log\left(\dfrac{2}{\alpha}\right)dB$ .

FIG. 1A

120

FIG. 1B

<u>200</u>

FIG. 2

<u>300</u>

FIG. 3

410

310

$Z_{opt,BO}$

Main Amplifier

$Z_{off} // Z_{combine}$

$L_{P1}$    $TL_{Main}$

311

312

Auxiliary Amplifier
(Closed)

$L_{P2}$    $TL_{Aux}$

313

314

Merging
Matching Network

Radio-Frequency
Output

Load

$Z_{off}$    $Z_{combine}$

FIG. 4A

420

310

$Z_{opt,M}$

Main Amplifier

$(1+I_{T2}/I_{T1})*Z_{combine}$

$L_{P1}$    $TL_{Main}$

$U_{T1}$

311

$I_{T1}$

312

$Z_{opt,A}$

Auxiliary Amplifier

$L_{P2}$    $TL_{Aux}$

$U_{T2}$

313

314

Merging
Matching Network

Radio-Frequency
Output

Load

$I_{T2}$

$(1+I_{T1}/I_{T2})*Z_{combine}$    $Z_{combine}$

FIG. 4B

<u>500</u>

FIG. 5

<u>600</u>

FIG. 6

700

FIG. 7

810

FIG. 8A

820

FIG. 8B

830

FIG. 8C

900

FIG. 9

1010

FIG. 10A

<u>1020</u>

FIG. 10B

<u>1100</u>

FIG. 11

Selecting transistors for the main amplifier and the auxiliary amplifier ⟋ 1210

Determining a target back-off power range of the Doherty amplifier, and according to the target back-off power range, the first inductance value of the first inductor, the second inductance value of the second inductor, the drain parasitic capacitance of the transistors, the center operating frequency of the Doherty amplifier, and the optimal operating load, determining a first characteristic impedance of the first transmission line, a first electrical angle of the first transmission line, a second characteristic impedance and a second electrical angle of the second transmission line ⟋ 1220

According to the center operating frequency, the first characteristic impedance of the first transmission line, the first electrical angle of the first transmission line, the second characteristic impedance of the second transmission line, the second electrical angle of the second transmission line, the optimal operating load, the first inductance value of the first inductor, the second inductance value of the second inductor, and the target back-off power range, determining a node impedance at the combining node ⟋ 1230

## FIG. 12

## 1310

FIG. 13A

<u>1320</u>

FIG. 13B

<u>1330</u>

FIG. 13C

1340

FIG. 13D

## INTERNATIONAL SEARCH REPORT

| International application No. |
|---|
| **PCT/CN2021/140419** |

**A.   CLASSIFICATION OF SUBJECT MATTER**

H03F 1/56(2006.01)i;  H03F 1/02(2006.01)i

According to International Patent Classification (IPC) or to both national classification and IPC

**B.   FIELDS SEARCHED**

Minimum documentation searched (classification system followed by classification symbols)

H03F

Documentation searched other than minimum documentation to the extent that such documents are included in the fields searched

Electronic data base consulted during the international search (name of data base and, where practicable, search terms used)

CNKI, CNPAT, EPODOC, WPI: 多赫蒂放大器, 输出网络, 主, 辅, 组合节点, 匹配网络, 电感, 串联, 传输线, 阻抗匹配, Doherty power amplifier, load match+, inductance, combining node, transmission line, master, slave

**C.   DOCUMENTS CONSIDERED TO BE RELEVANT**

| Category* | Citation of document, with indication, where appropriate, of the relevant passages | Relevant to claim No. |
|---|---|---|
| X | US 2021376798 A1 (NXP USA, INC.) 02 December 2021 (2021-12-02) description, paragraphs 17-18, 20, 42, 46, 50, and 52, and figure 1 | 1-18 |
| X | CN 113826320 A (MITSUBISHI ELECTRIC CORP.) 21 December 2021 (2021-12-21) description, paragraphs 72-74, 79-80, 87-88, 115-118, and 457-479, and figures 3 and 16-17 | 1-18 |
| A | US 2021050821 A1 (GATESAIR, S. R. L.) 18 February 2021 (2021-02-18) entire document | 1-18 |
| A | CN 113632372 A (PANASONIC IP MAN CO., LTD.) 09 November 2021 (2021-11-09) entire document | 1-18 |
| A | CN 111416578 A (GAXTREM TECHNOLOGY (BEIJING) CO., LTD. et al.) 14 July 2020 (2020-07-14) entire document | 1-18 |
| A | US 2019229686 A1 (CREE, INC.) 25 July 2019 (2019-07-25) entire document | 1-18 |
| A | CN 111510077 A (INNOGRATION (SUZHOU) CO., LTD.) 07 August 2020 (2020-08-07) entire document | 1-18 |

☐ Further documents are listed in the continuation of Box C.      ☑ See patent family annex.

| | |
|---|---|
| *    Special categories of cited documents: <br> "A"  document defining the general state of the art which is not considered to be of particular relevance <br> "E"  earlier application or patent but published on or after the international filing date <br> "L"  document which may throw doubts on priority claim(s) or which is cited to establish the publication date of another citation or other special reason (as specified) <br> "O"  document referring to an oral disclosure, use, exhibition or other means <br> "P"  document published prior to the international filing date but later than the priority date claimed | "T"  later document published after the international filing date or priority date and not in conflict with the application but cited to understand the principle or theory underlying the invention <br> "X"  document of particular relevance; the claimed invention cannot be considered novel or cannot be considered to involve an inventive step when the document is taken alone <br> "Y"  document of particular relevance; the claimed invention cannot be considered to involve an inventive step when the document is combined with one or more other such documents, such combination being obvious to a person skilled in the art <br> "&"  document member of the same patent family |

| Date of the actual completion of the international search | Date of mailing of the international search report |
|---|---|
| **03 August 2022** | **29 August 2022** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/140419**

| Patent document cited in search report | | | Publication date (day/month/year) | Patent family member(s) | | | Publication date (day/month/year) |
|---|---|---|---|---|---|---|---|
| US | 2021376798 | A1 | 02 December 2021 | None | | | |
| CN | 113826320 | A | 21 December 2021 | WO | 2020217422 | A1 | 29 October 2020 |
| | | | | JP | 6779391 | B1 | 04 November 2020 |
| | | | | WO | 2020217422 | X | 06 May 2021 |
| | | | | US | 2022021345 | A1 | 20 January 2022 |
| | | | | EP | 3944493 | A1 | 26 January 2022 |
| US | 2021050821 | A1 | 18 February 2021 | BR | 102020014614 | A2 | 26 January 2021 |
| | | | | EP | 3767826 | A1 | 20 January 2021 |
| | | | | IT | 201900011967 | A1 | 17 January 2021 |
| CN | 113632372 | A | 09 November 2021 | JP | WO2020202674 | A1 | 04 November 2021 |
| | | | | WO | 2020202674 | A1 | 08 October 2020 |
| | | | | US | 2022021344 | A1 | 20 January 2022 |
| CN | 111416578 | A | 14 July 2020 | None | | | |
| US | 2019229686 | A1 | 25 July 2019 | EP | 3724991 | A1 | 21 October 2020 |
| | | | | WO | 2019147666 | A1 | 01 August 2019 |
| | | | | JP | 2021512565 | A | 13 May 2021 |
| | | | | KR | 20200110663 | A | 24 September 2020 |
| | | | | US | 2019341893 | A1 | 07 November 2019 |
| CN | 111510077 | A | 07 August 2020 | WO | 2021212818 | A1 | 28 October 2021 |

Form PCT/ISA/210 (patent family annex) (January 2015)